# EUROPEAN PATENT APPLICATION

(11) **EP 4 832 434 A1**
(43) Date of publication of application: **28.10.2026**
(21) Application number: 25171953.0
(22) Date of filing: 23.04.2025
(51) Int. Cl.: H04L 41/0631, H04L 41/12, G01R 31/08, H04L 41/0677, H04L 41/14, H04L 41/40, H04L 41/5074

(54) **DISTRIBUTED PROCESSING OF INFORMATION FOR POWER OUTAGE INFERENCE AND MANAGING POWER DISTRIBUTION SYSTEMS**

(71) Applicant: Hitachi Energy Ltd, 8050 Zürich (CH)
(72) Inventor: BOMBA, Piotr, 26-400 Lipno (PL); CHMIELOWIEC, Krzysztof, 32-089 Beblo (PL); WANG, Zhenyuan, Apex, 27502 (US); KNEZOVIC, Katarina, 8006 Zurich (CH); SHIRSAT, Ashwin, Apex, 27523 (US); EKOMWENRENREN, Etinosa, Longueuil, J4K 4Y6 (CA); SHCHETININ, Dmitry, 5600 Lenzburg (CH); DAWIDOWSKI, Pawel, 32- 010 Luczyce (PL)
(74) Representative: Valea AB

(57) **Abstract**

The invention addresses the problem of efficiently managing and analyzing large, dynamic power distribution system topologies in a distributed manner, avoiding centralized bottlenecks. The solution involves partitioning the topology into directed network models (2021a, 2022a), each stored in a container (2001, 2002) of a set. Event messages (102, 2010a) (add/remove edge, trouble report) are broadcast to all containers. Each container independently determines relevance to its model. Relevant operations are performed autonomously: executing power diagnosis (103) for trouble reports; removing edges (104), potentially splitting (104c) the model and initiating a new container (104d); or adding edges (105), potentially merging (1042) containers if nodes span models. This facilitates scalable topology management and diagnostics. The main use is within Outage Management Systems (2000) for monitoring, analysis, and control of power distribution systems.

## Description

### TECHNICAL FIELD

The present disclosure relates generally to the field of power distribution system management. More specifically, it pertains to systems and methods for distributed processing of information related to the topology of power distribution systems, including the handling of operational events, such as physical changes in the state of the power distribution network (e.g., a breaker opening) or indicators of potential problems or service issues.

### BACKGROUND

Power distribution networks form the critical infrastructure for delivering electricity from transmission systems to end consumers. The effective management and operation of these networks rely heavily on sophisticated software systems, including Advanced Distribution Management Systems (ADMS), a key component of which is often an Outage Management System (OMS). A primary function of an OMS is to process incoming data, such as customer-initiated trouble reports or automated sensor readings (e.g., from SCADA systems), to infer the location and cause of power outages. This typically involves identifying the status or tripping of protection devices like fuses, circuit breakers, and reclosers within the network topology.

To facilitate analysis, the topology of a power distribution system is frequently modeled as a graph, specifically a directed network model. In such models, nodes commonly represents entities like loads, power sources, transformers, or connection points, while edges represents power carrying lines or electrical devices (e.g., switches, protection devices) connecting these nodes. Algorithms operating on this graph model are essential for core OMS functionalities, including outage inference, switching plan generation, and restoration management.

However, contemporary power distribution networks can be geographically extensive and topologically complex, leading to very large graph models. Processing events against these monolithic models presents significant computational challenges. For instance, during abnormal operating conditions, such as severe weather events ("storm scenarios"), an OMS may be inundated with hundreds or thousands of concurrent trouble reports. Performing diagnostic analyses (e.g., outage inference) or processing topology updates (reflecting network reconfiguration or repairs) across the entirety of a large, centralized graph model can result in substantial processing delays and system bottlenecks. Such delays are detrimental to the goal of rapid fault location and service restoration.

Various approaches exist for managing computational tasks and data. Distributed computing paradigms aim to divide tasks across multiple processing units. Furthermore, software containerization technologies, such as Docker or Kubernetes environments, have become prevalent for packaging, deploying, and isolating application components, ensuring consistent operation across different computing environments. Systems employing message-based coordination between containerized tasks for general job flow execution are known (cf. US 11,080,031 B2). Additionally, graph data structures themselves are utilized in various management tools, for example, to model service architectures and dependencies (cf. US 11,425,217 B1). Other uses of "container" concepts exist in data management, for instance, related to storing and updating versions of information objects (cf. US 5,873,097 A). Research also explores efficient graph *data structures* (sometimes termed 'graph containers') for optimizing algorithm performance on large graphs (cf. Wheatman et al., "BYO: A Unified Framework for Benchmarking Large-Scale Graph Containers," 2024), though this typically focuses on data representation rather than distributed execution architecture using software virtualization containers.

Despite these advancements, challenges remain in efficiently managing and processing dynamic events pertaining to very large graph models representing power distribution systems. There is a need for architectures that can effectively partition such large graph models, particularly for handling topology-specific events like fault diagnosis or network updates, in a scalable and parallel manner. Existing systems may not adequately alleviate the bottlenecks associated with centralized, monolithic graph processing, especially under high-load conditions.

### SUMMARY

Aspects of the present disclosure relate generally to systems and methods for managing information pertaining to a power distribution system, offering technical advantages in terms of computational efficiency, scalability, and robustness, particularly when handling topology-specific events in large-scale networks. The disclosed approaches address the problem of processing bottlenecks associated with centralized, monolithic graph models, especially under high-load conditions such as storm scenarios.

### First aspect

According to an first aspect, a method performed by a network node facilitates distributed management and analysis of a power distribution system topology. The method comprises retrieving a set of containers, wherein each container comprises a directed network model reflecting the topology of a unique section of the power distribution system. These models include nodes (representing loads or sources) and edges (representing protection devices or power lines). An event message-comprising either an add edge request, an edge removal request, or a trouble report associated with a node-is transmitted to each container in the set. Within each container, a set of operations is performed, adapted for independent processing relative to other containers. This set of operations comprises determining if a node or edge associated with the event message is associated with the container's specific directed network model, thereby distributing the relevancy check and mitigating central orchestration bottlenecks. Based on this determination and the event message type, specific suboperations are performed: a first set of suboperations involves performing a power distribution diagnosis if the message is a relevant trouble report; a second set of suboperations involves removing the relevant edge from the model if the message is a remove edge request; and a third set involves adding an edge between relevant nodes if the message is an add edge request. This distributed processing architecture enables efficient parallel handling of events.

### Second aspect

According to a second aspect, an outage management system (OMS) is provided, configured to implement such distributed management. The system comprises an OMS input interface for retrieving an event message (add edge, remove edge, or trouble report), an OMS output interface, and an OMS processor communicatively coupled between them. The OMS processor is configured to receive the event message and cause the OMS output interface to transmit it to a set of container systems. Each container system comprises a container input interface, a container memory storing a directed network model of a unique PDS section, a container processor, and a container output interface. The container processor is communicatively coupled to its input interface and memory and is configured to perform operations independently upon receiving an event message. These operations mirror the method's suboperations: determining relevancy of the event message to its stored model, and if relevant: executing a power distribution diagnosis (generating a diagnosis result output via the container output interface) for a trouble report; modifying the model to remove an edge for a remove edge request; or modifying the model to add an edge for an add edge request. This system architecture provides a configuration for achieving the parallel processing and scalability benefits.

### First & second aspect

In various embodiments applicable to both the method and system aspects, the processing of event messages may include further topology management operations. For instance, when processing a remove edge request (the second set of suboperations), the operations may further comprise determining if the edge removal necessitates splitting the container's directed network model. If a split is required, the model is split into a first and second directed network model, the first remains in the current container/container system, and a new container/container system is initiated to comprise the second directed network model, thereby dynamically maintaining the partitioned representation across the set of containers.

Furthermore, embodiments addressing the processing of an add edge request (the third set of suboperations) may handle scenarios where the nodes to be connected reside in different containers/container systems. The operations may comprise determining if both nodes are within the current container's model (in which case the edge is added internally), or if only a first node is present. If only the first node is present, a merging operation is initiated with the other container/container system holding the second node, resulting in a merged model within a single container/container system where the new edge is added. This allows for dynamic consolidation of topology partitions.

A specific mechanism for performing such a merging operation, applicable in certain embodiments of both aspects, involves designating one of the two containers/container systems for removal. The container/container system designated for removal transmits a push merge message (comprising at least its directed network model and the original event message) to all other containers/container systems. A receiving container/container system determines if it holds the second node specified in the event message; if so, it merges the received model with its own and adds the connecting edge within the resulting merged model. This provides a robust, distributed protocol for executing merge operations.

These approaches, by distributing the topology model and processing logic across independent containers, provide a technical solution for efficiently managing dynamic events in complex power distribution networks, enhancing the responsiveness and reliability of outage management and network maintenance operations.

### SUMMARY OF FIGURES

FIG.1 illustrates a embodiment according to first aspect of the present invention.
FIG. 2 illustrates an embodiment according to the first aspect relating to a second set of suboperations.
FIG. 3 illustrates an embodiment according to the first aspect relating to a third set of suboperations.

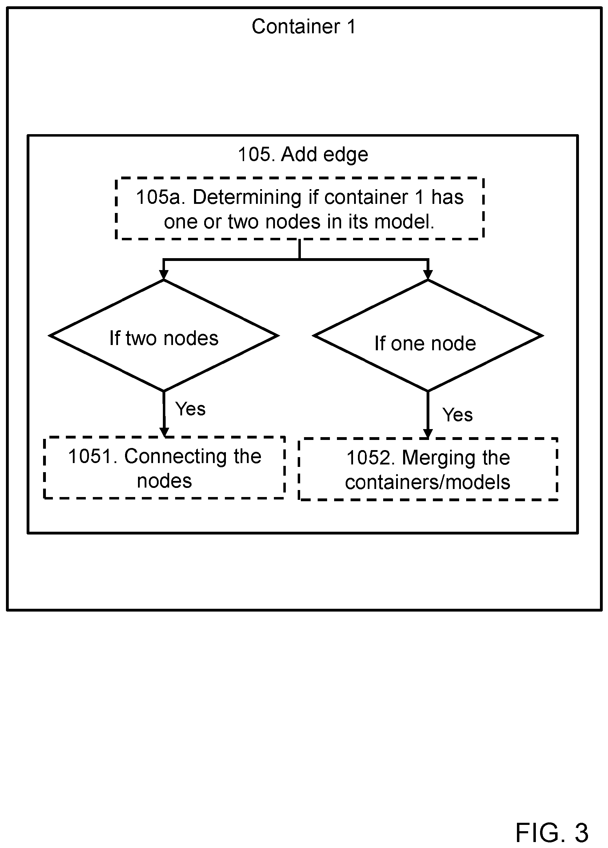

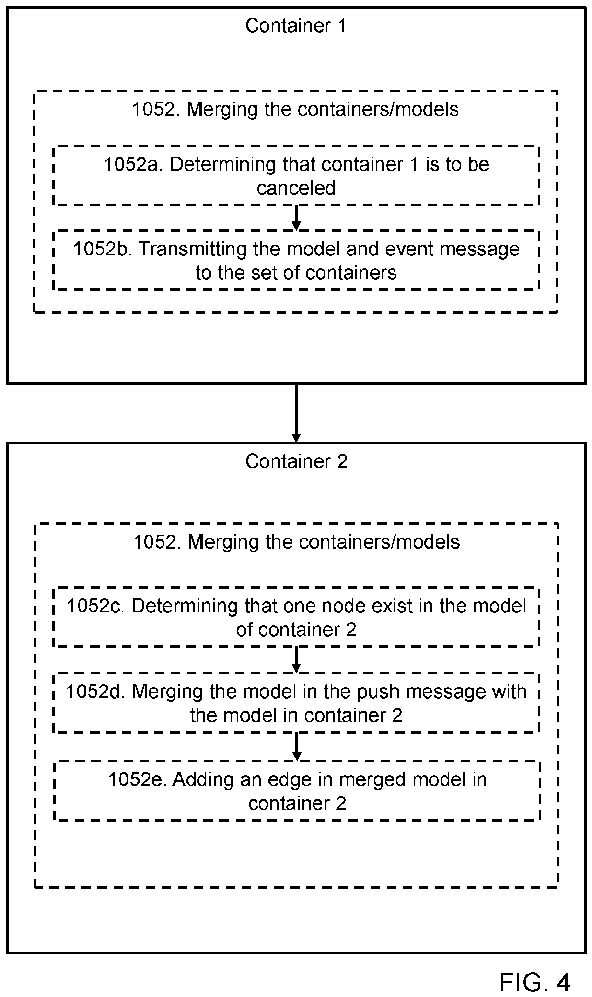

FIG. 3 & 4 illustrates embodiments according to the first aspect relating to a third set of suboperations.

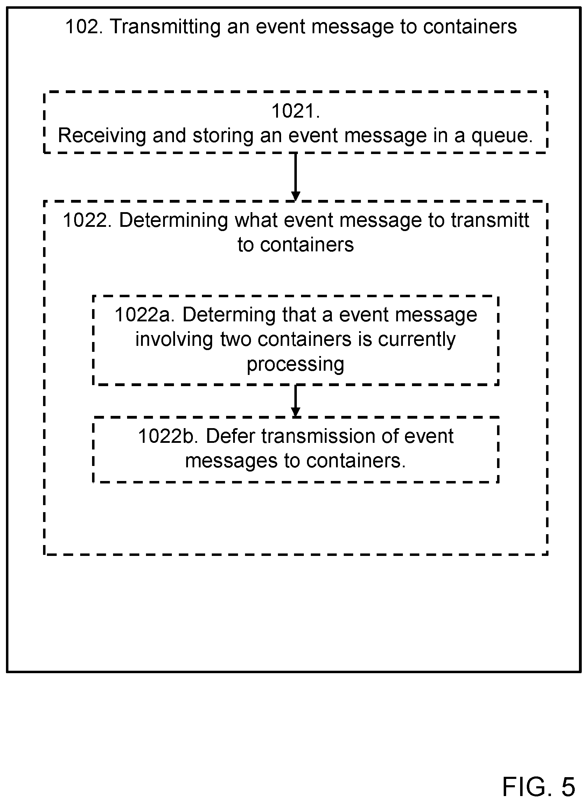

FIG. 5 illustrates embodiments according to the first aspect relating to transmission of event messages to containers.

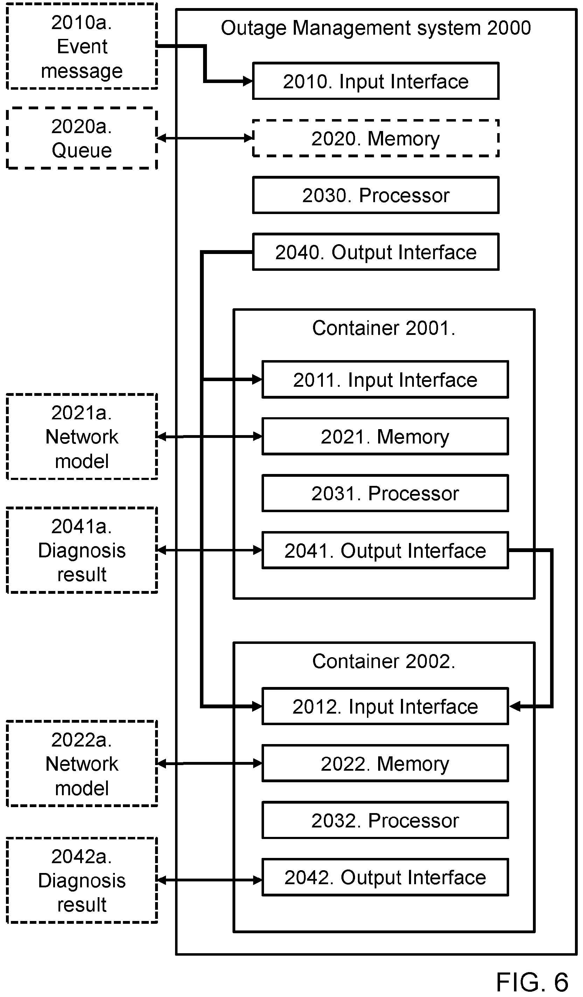

FIG.6 illustrates an embodiment according to the second aspect of the present invention.

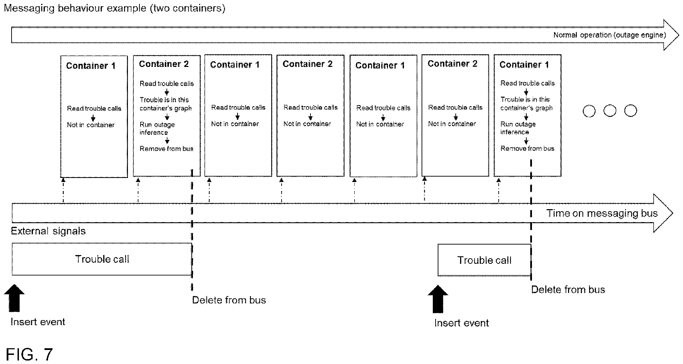

FIG. 7 - 14 illustrate non-limiting examples of the behavior and operations of the method and outage management system according to various embodiments of the present invention.

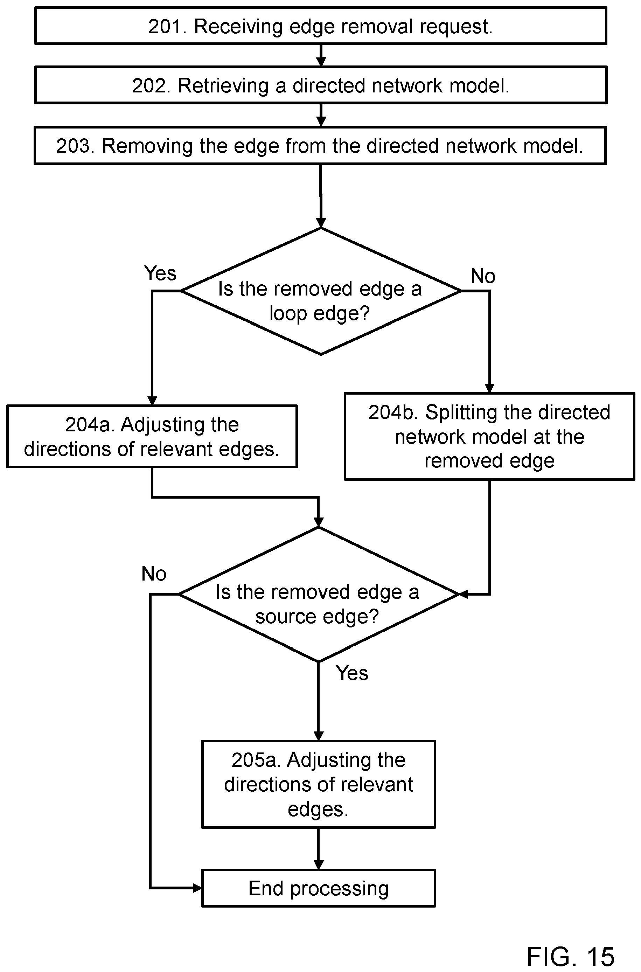

Fig. 15-16 and 20 illustrates embodiments according to the third aspect.

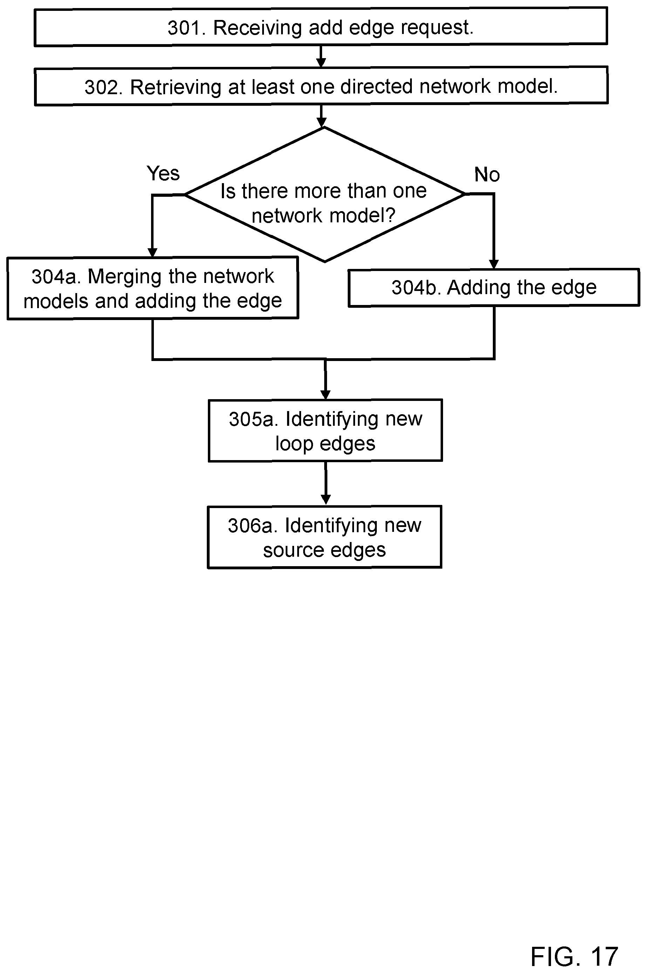

Fig. 17-18 and 21 illustrate embodiments according to the fourth aspect.

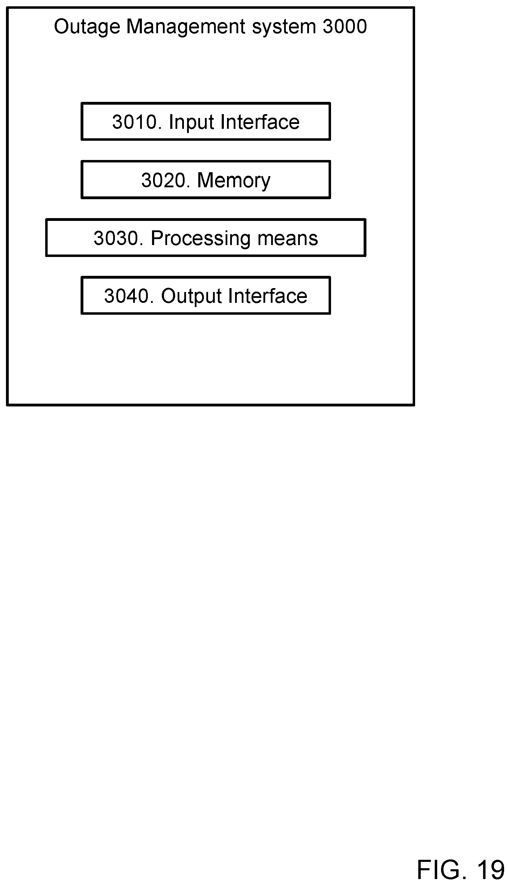

Fig. 19 illustrates embodiments according to the fifth aspect.

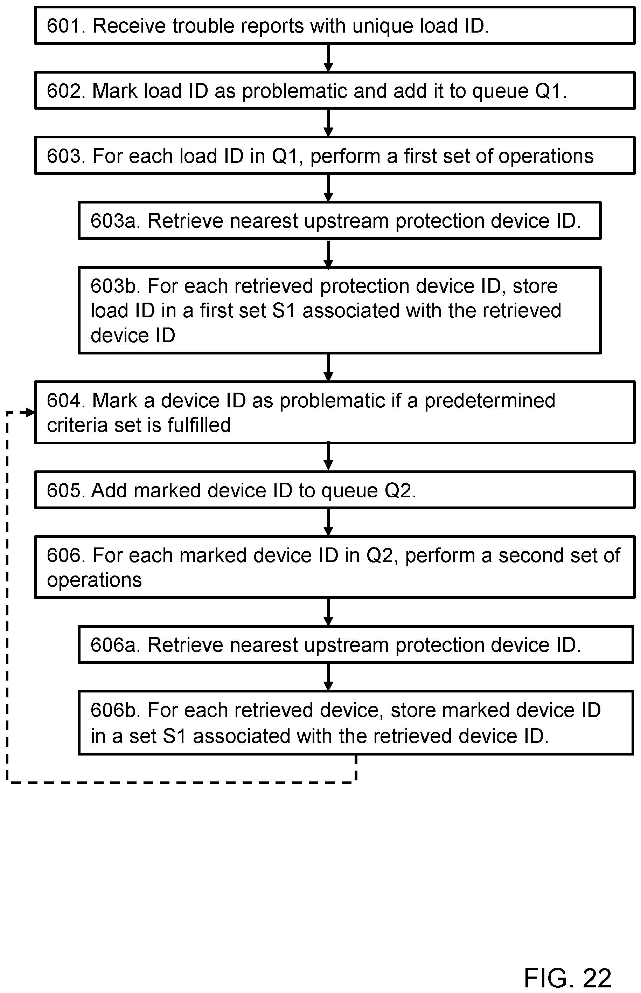

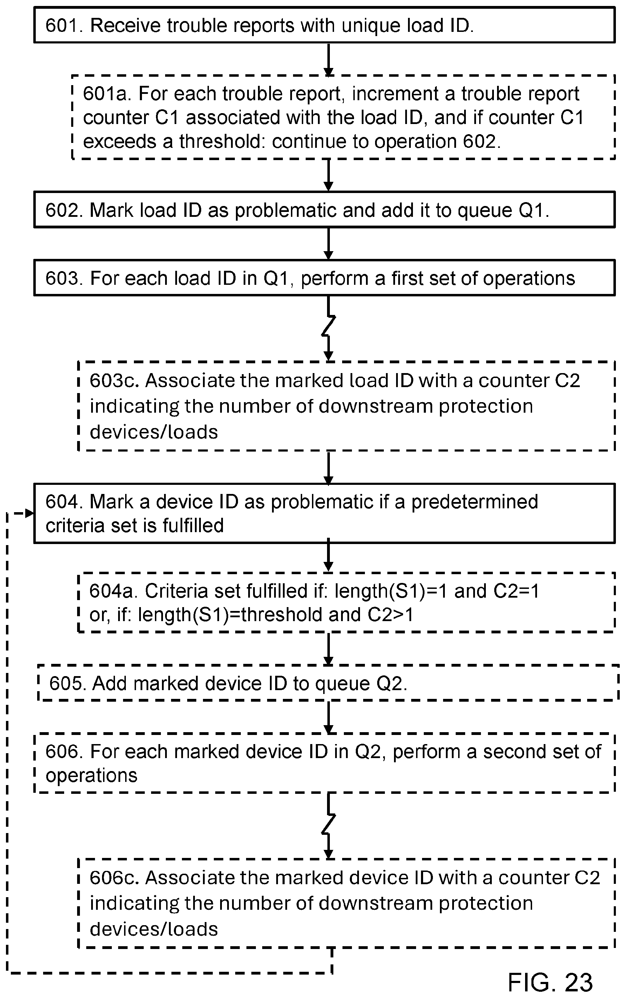

Figure 22 and 23 illustrate embodiments according to the sixth and seventh aspect.

### DETAILED DESCRIPTION

### First aspect

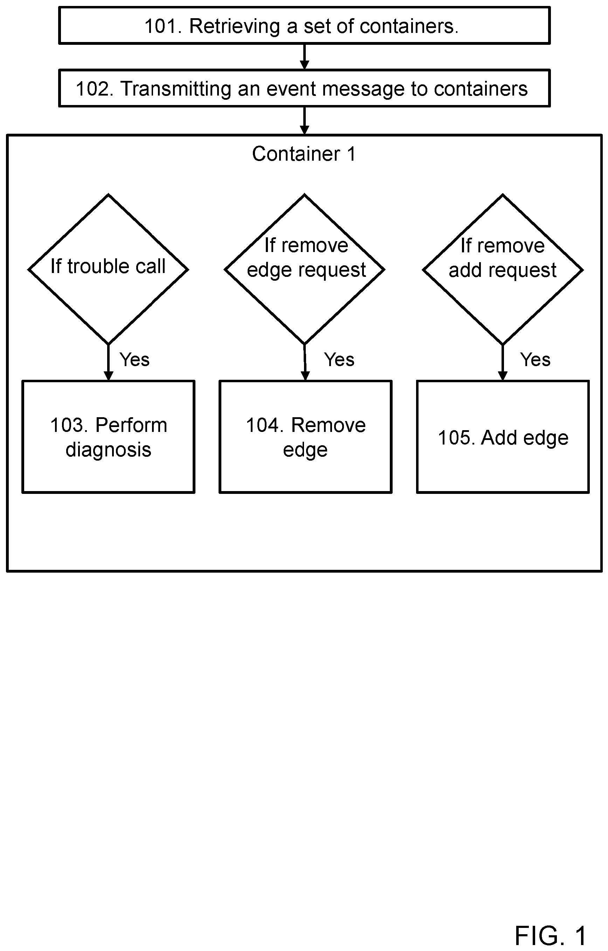

FIG. 1 illustrates a method according to a first aspect of the present invention, performed by a network node. The method facilitates distributed management and analysis of a power distribution system topology.

The method commences with the network node retrieving **101** a set of containers. Each container within this set encapsulates or stores a directed network model. These directed network models are representations of the topology of a power distribution system. Specifically, each directed network model includes a plurality of nodes and edges. Within such models, each node represents at least one load or power source present in the power distribution system. Furthermore, each edge represents at least one protection device (e.g., a fuse, breaker, or recloser) or a power carrying line that connects two nodes. Each directed network model held within a container in the retrieved set reflects a unique, distinct section or partition of the overall topology of the power distribution system. This partitioning allows for segmented management and processing.

Following the retrieval of the container set, the network node proceeds to transmit 102 an event message to each of the containers in the set. This transmission broadcasts or disseminates information pertinent to potential topology changes or operational issues. The event message itself comprises, or alternatively consists of, specific operational instructions or notifications. The event message comprises an add edge request, remove edge request or trouble report. The add edge request is associated with two specific nodes that are intended to be connected within the topology representation. The edge removal request is associated with a particular edge designated for removal from the topology representation. The trouble report is associated with a specific node that has been previously identified or determined to be linked to a power distribution problem or fault.

Subsequently, upon receiving an event message, a set of operations is performed within each container belonging to the set of containers. These operations are adapted for independent processing, meaning the operations within one container can proceed autonomously relative to the operations in other containers. This distributed processing is initiated in response to the container receiving the event message transmitted in step **102.**

A preliminary operation within each container involves determining if a node or edge associated with the received event message is associated with, i.e., corresponds to, a node or edge already present within the specific directed network model comprised in that container. This acts as a relevancy filter and eliminates the need for a central orchestration mechanism assigning event messages to specific containers based on a database storing all node and edge identification codes, thus offering a more robust processing and mitigating the bottlenecks associated with such central orchestration mechanisms.

Based on the type of event message received and the outcome of the relevancy determination (i.e., if the message pertains to the model within the container), specific suboperations are performed. The set of operations comprises distinct sets of suboperations corresponding to the different types of event messages.

A first set of suboperations is executed if the event message is determined to be a trouble report and if the associated node/edge is relevant to the container's model. This set of operation involves performing **103** a power distribution power diagnosis. This diagnosis is based on the node and/or edge identified in the trouble report and utilizes the topological information contained within the directed network model comprised in the container currently processing the message.

The set of operations further comprises a second set of suboperations, executed if the event message is determined to be a remove edge request and the relevant edge exists within the container's model. This set of operation involves removing **104** the edge associated with the remove edge request from the directed network model stored within the container. This action updates the local topology representation to reflect the removal.

Additionally, the set of operations comprises a third set of suboperations, executed if the event message is determined to be an add edge request and the relevant nodes exist within the container's model. This set of operations involves adding **105** an edge by connecting the two nodes associated with the add edge request. This connection is achieved by adding a corresponding edge to the directed network model maintained within the container, thereby updating the local topology representation.

As used herein, the term "power distribution problem diagnosis" shall be understood to encompass the computational analysis, preferably performed within a container utilizing, at least in part, the directed network model stored therein. The diagnosis process is directed towards identifying, locating, characterizing, or otherwise determining information pertaining to the underlying cause or extent of the power distribution problem indicated by, or related to, the received trouble report, within the context of the topological section represented by the container's directed network model. The execution of the power distribution problem diagnosis yields a diagnosis result, which may include, without limitation, identification of a likely fault location (e.g., a specific edge or node), determination of affected downstream customers, assessment of protection device operation, or propagation of fault status information. This diagnosis is performed based on the data available within the container, including the directed network model and the specifics of the trouble report, enabling independent processing relative to other containers managing different sections of the overall power distribution system topology.

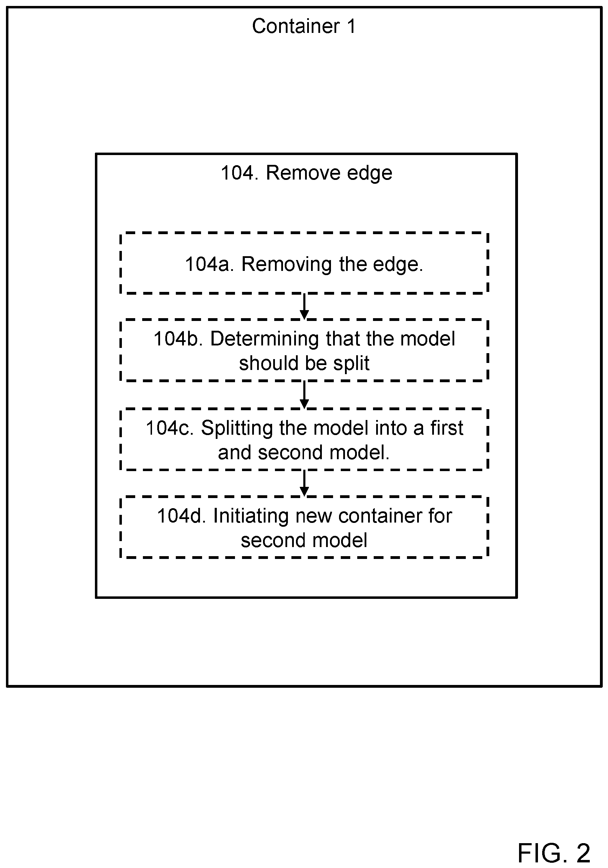

**FIG.** 2 illustrates a specific embodiment refining the second set of suboperations (triggered by a remove edge request). The illustrated actions may be performed within the container after removing **104a** the edge associated with the request.

Following the removal of the designated edge **104a,** a determination **104b** is made within the Container 1 regarding whether the removal necessitates splitting the container's directed network model. This situation might arise if the edge removal disconnects a previously connected portion of the network represented within that single model.

If the determination **104b** concludes that the directed network model should be split, the splitting operation **104c** is performed. This operation divides the original directed network model into a first directed network model and a second directed network model. The first directed network model refers to the model that remains within the current container.

Concurrently, or subsequently, a new container is initiated **104d.** This new container is specifically created to comprise, or store, the second directed network model resulting from the split **104c.** Importantly, this newly initiated container is then included in, or added to, the set of containers being managed by the network node, ensuring the complete topology remains represented across the container set, albeit now distributed over an additional container.

**FIG.** 3 shows a embodiment elaborating on the third set of suboperations (triggered by an add edge request). This process commences after an add edge request, associated with two nodes to be connected, is received by a container and deemed relevant for that container.

A determination **104a** is made within the container processing the request. This determination ascertains whether one or both of the nodes specified in the add edge request correspond to nodes already present within the directed network model stored in that particular container.

Two distinct outcomes arise from this determination **104a:**
1. If the determination **104a** reveals that both nodes targeted by the add edge request are associated with (i.e., exist within) the directed network model comprised in the current container, then the operation proceeds to connect **1041** these two nodes. This connection is achieved by adding the specified edge directly within the existing directed network model of the container.
2. Alternatively, if the determination **104a** reveals that only a first node among the two nodes specified in the request is associated with the directed network model in the current container (implying the second node resides in a model within a different container), then a merging operation **1042** is initiated. This operation involves merging the current container (containing the first node) with another container from the set. This other container is the one whose directed network model is associated with the second node specified in the add edge request. The result of the merging operation **1042** is typically a single, combined container holding a merged directed network model. Crucially, during or after the merge, the new edge is added to this merged model, connecting the first node and the second node as requested by the original event message.

**FIG.** 4 illustrates a specific implementation of the merging operation **1042** introduced in the context of the edge addition embodiment (FIG. 3). This merging process is employed when an add edge request requires connecting a node in one container (e.g., Container 1) to a node in another container (e.g., Container 2).

The merging process may commence with a determination **1042a** regarding which of the two involved containers (the container processing the request, Container 1, or the other container holding the second node, Container 2) should be canceled (i.e., removed) from the active set of containers. This decision could be based on criteria such as model size, container load, or predefined rules (e.g., the model comprising node that is to the left is kept). FIG. 4 depicts the scenario where Container 1 is selected for cancellation.

The container designated for removal (Container 1 in this illustration) then performs a specific set of actions. It transmits **1042b** a push merge message. This message is disseminated or broadcast to each container currently in the set of containers. The push merge message contains at least the directed network model comprised in the container to be removed (Container 1's model) and typically includes the original event message (the add edge request) that triggered the merge.

Each container in the set receives this push merge message. In response, each receiving container performs a check. For instance, Container 2, upon receiving the push message from Container 1, determines **1042c** if the second node (the one specified in the original add edge request that was not found in Container 1) is associated with the directed network model comprised within itself (Container 2).

If the determination **1042c** is positive (meaning Container 2 holds the second node), it proceeds to merge **1042d** the directed network model received in the push merge message (originally from Container 1) with its own directed network model. As part of this merge, or subsequent to it, the new edge specified in the original add edge request is added, connecting the first node (now integrated from Container 1's model) and the second node (already present in Container 2's model) within the consolidated, merged directed network model residing in the remaining container (Container 2). Following this, Container 1 can be considered effectively removed or decommissioned from the set of containers.

In one embodiment of the first aspect the method further comprises:
- generating, by the network node and based on said power distribution problem diagnosis, an alert message identifying a protection device experiencing a power distribution problem; and
- transmitting said alert message for display on a graphical user interface associated with an Outage Management System (OMS) configured for monitoring and managing the power distribution system.

In another embodiment of the first aspect the method further comprises:
- generating, by the network node and based on said power distribution problem diagnosis, control data specifying a protection device identified as experiencing a power distribution problem; and
- transmitting said control data to an automated switching system or control interface configured to utilize said control data to perform a switching operation within the power distribution system related to the identified protection device.

In yet another embodiment of the first aspect the method further comprises:
- initiating, by the network node via an interface to an Outage Management System (OMS) and based on said power distribution problem diagnosis, an operational workflow within the OMS, wherein said operational workflow includes procedures for dispatching a repair crew to a geographic location corresponding to a protection device marked as experiencing a power distribution problem.

### Second aspect

**FIG. 6** illustrates a embodiment according to second aspect of the present invention concerning an outage management system **2000.** This system **2000** provides hardware and processing capabilities configured to implement distributed management and analysis of a power distribution system topology.

The outage management system **2000** comprises a main outage management system input interface **2010.** This input interface **2010** is configured to receive an event message **2010a.** The event message **2010a,** potentially received via an external source or queue (illustrated optionally as **2020a),** comprises operational instructions or notifications related to the power distribution system. Specifically, the event message comprises either: i) an add edge request associated with two nodes intended for connection within the power distribution system topology; ii) an edge removal request associated with an edge designated for removal; or, iii) a trouble report associated with a node identified as potentially having a power distribution problem.

The system **2000** further includes a main outage management system output interface **2040** and a main outage management system processor **2030.** This processor **2030** is communicatively coupled to both the main input interface **2011** and the main output interface **2040.** The main processor **2030** is configured to perform specific tasks. It retrieves the event message **2010a** via the main input interface **2010.** Optionally, incoming messages might be temporarily stored in a queue or main memory **2020** associated with the main processor. Upon receiving the event message, the main processor **2030** is configured to cause the main output interface **2010** to transmit the received event message onward.

The transmitted event message is directed to a set of container systems, exemplified by Container **2001** and Container **2002** in FIG. 6. Each container system within this set represents a distinct processing entity.

In the illustrated embodiment, each container system, e.g., **2001, 2002,** comprises several components. It includes a container input interface **2011, 2012** which is communicatively coupled to the main outage management system output interface **2040** to receive the transmitted event messages.

Furthermore, each container system includes a container memory **2021, 2022.** This memory is configured to store a directed network model **2021a, 2022a.** Each stored directed network model reflects the topology of a unique section or partition of the overall power distribution system. The directed network model itself includes a plurality of nodes, representing elements like loads or power sources, and a plurality of edges, representing components such as protection devices or power carrying lines connecting two nodes. The network model **2021a, 2022a** is thus stored within the respective container memory **2021, 2022.**

Each container system also comprises a container processor **2031, 2032.** This container processor is communicatively coupled to its respective container input interface **2011, 2012** and its container memory **2021, 2022.** The container processor **2031, 2032** is configured to execute operations in response to receiving an event message via the container input interface **2011, 2012.** These operations are specifically adapted for independent processing, allowing each container system to operate autonomously relative to other container systems in the set upon receiving a message.

The set of operations performed by the container processor **2031, 2032** includes first determining if a node or edge associated with the received event message corresponds to a node or edge within the directed network model **2021a, 2022a** stored in its container memory **2021, 2022.**

If such a correspondence is found (i.e., the message is relevant to this container's section of the topology), the container processor proceeds to perform specific suboperations based on the message type:
- A first set of suboperations involves: if the event message is identified as a trouble report, executing a power distribution diagnosis. This diagnosis utilizes the corresponding node and/or edge from the message and the data within the directed network model **2021a, 2022a** stored in the container memory **2021, 2022.** The diagnosis process generates a diagnosis result **2041a, 2042a.**
- A second set of suboperations involves: if the event message is identified as a remove edge request, modifying the directed network model **2021a, 2022a** stored in the container memory **2021, 2022.** The modification consists of removing the corresponding edge from the model representation.
- A third set of suboperations involves: if the event message is identified as an add edge request, modifying the directed network model **2021a, 2022a** stored in the container memory **2021, 2022.** This modification consists of adding an edge that connects the two corresponding nodes within the model representation.

Finally, each container system **2001, 2002** includes a container output interface **2041, 2042.** This output interface is communicatively coupled to the container processor **2031, 2032.** It is configured to output information resulting from the processor's operations, including at least the diagnosis result **2041a, 2042a** when generated. As indicated in the figure description, this output interface **2041, 2042** may also be configured for communication with other container systems (e.g., transmitting push merge messages between **2041** and **2012)** or potentially back to the main outage management system input interface **2010** in certain embodiments.

It should be understood that the depiction in FIG. 6, illustrating an outage management system **2000** encompassing two container systems **2001, 2002,** is exemplary. The principles of the invention accommodate a set of container systems comprising any number of two or more container systems, scalable according to the size and complexity of the power distribution system topology being managed.

Furthermore, the representation of container systems **2001, 2002** as notionally residing *inside* the outage management system **2000** is primarily a logical or functional illustration. Meaning that, the outage management system **2000** may be communicatively coupled to the container system **2001, 2002** and not comprise the container system **2001, 2002** per se. Additionally, the outage management system **2000** may incorporate numerous additional functions typical of such systems (e.g., crew management, reporting, customer communication interfaces), which are not explicitly detailed but may coexist.

The container systems **2001, 2002** and the main outage management system components **2010, 2020, 2030, 2040** may but need not be co-located on a single physical device. Instead, they may represent functional partitions distributed across multiple computing devices, servers, or virtualized environments interconnected via suitable communication networks. Consequently, the processors **2030, 2031, 2032** and memories **2020, 2021, 2022** shown may correspond to distinct physical hardware units, or they could represent logical allocations of shared physical hardware resources, such as different cores of a multi-core processor or partitioned segments of a common physical memory system.

In one embodiment according to the second aspect, the container processor **2031, 2032** within each container system **2001, 2002** possesses an configuration for handling the second set of suboperations, specifically when processing a remove edge request. As part of these operations, the container processor is configured to determine if the removal of the corresponding edge would result in splitting the directed network model **2021a, 2022a** currently stored in the container memory **2021, 2022** into two distinct topological sections, representable as a first directed network model and a second directed network model.

Should the container processor determine that such a split occurs, it is further configured to execute several actions. It logically splits the original directed network model into the first and second directed network models. It then modifies the container memory **2021, 2022** it is coupled to, such that the memory stores the first directed network model (representing one part of the split topology). Concurrently or subsequently, the container processor initiates a new container system. This newly initiated container system is configured with the second directed network model (representing the other part of the split topology), effectively adding another independent processing unit to the overall set of container systems managed by the outage management system **2000.**

In some embodiments, the configuration of the container processor **2031, 2032** may be further adapted for performing the third set of suboperations, specifically when handling an add edge request. In this embodiment, the container processor is configured to determine if one, or alternatively both, of the nodes specified in the add edge request correspond to nodes present within the directed network model **2021a, 2022a** stored in its associated container memory **2021, 2022.**

Based on this determination, the container processor proceeds differently. If the processor determines that both nodes correspond to nodes already existing within its stored directed network model, it modifies the model in the container memory **2021, 2022** by simply adding the new edge connecting the two corresponding nodes internally. However, if the processor determines that only a first node among the two specified in the request corresponds to a node in its stored model (implying the second node exists in the model of a different container system), the processor is configured to initiate a process for merging its own container system with that other container system associated with the second node.

In one embodiment relating to the merging process initiated in the previously described embodiment, the merging operation is coordinated, potentially starting with a container processor, e.g., **2031** configured to determine which of the two container systems identified for merging (e.g., its own system **2001** or the other system **2002)** is to be designated for removal or cancellation post-merge.

The container processor **2031** within the container system **2001** designated for removal is specifically configured for distinct actions. It generates a push merge message. This message includes at least the original add edge request that triggered the merge and the complete directed network model **2021a** stored in its container memory **2021.** The processor **2031** then causes this push merge message to be transmitted via its container output interface **2041** to the container input interface **2011, 2012** of each container system currently part of the set.

Correspondingly, the container processor of each container system (e.g., **2002** receiving the push merge message via its input interface **2012** is further configured to process it. It determines if the second node associated with the add edge request contained within the push merge message corresponds to a node within the directed network model **2022a** stored in its own container memory **2022.** If this condition is met, the receiving container processor **2032** proceeds to merge the directed network model received in the push message with the directed network model **2022a** stored locally in its memory **2022.** Subsequently, it adds the new edge, connecting the first node (from the merged model portion) and the second node (from its original model portion), within the resulting merged directed network model now stored in its container memory **2022.**

According to embodiments, the outage management system comprises a outage management system memory **2020,** which is communicatively coupled to the outage management system processor **2030.** The OMS processor **2030** may then further configured with additional capabilities beyond message reception and transmission.

In one embodiment, the OMS processor **2030** is configured to store the event messages **2010a** received via the OMS input interface **2010** into a messaging queue **2020a.** This queue **2020a** resides within the OMS memory **2020.** Furthermore, the OMS processor **2030** is configured to implement a predetermined prioritization protocol. Based on this protocol, the processor **2030** determines the order in which event messages stored in the messaging queue **2020a** should be selected and subsequently transmitted, via the OMS output interface **2040,** to the set of container systems **2001, 2002.**

A specific implementation of the predetermined prioritization protocol, executed by the outage management system processor **2030,** is described in one proposed embodiment. This protocol includes logic for managing system resources during potentially complex operations. It commences by the OMS processor **2030** determining if at least one container processor (e.g., **2031 or 2032** within the set of container systems is currently engaged in processing an event message that requires coordination between two container systems (for example, executing a merge operation as previously described).

If the OMS processor **2030** determines that such inter-container coordination processing is actively occurring, its configuration causes it to temporarily defer the transmission of any further event messages from the messaging queue **2020a** via the OMS output interface **2040.** This deferral continues until the OMS processor **2030** determines that no container processor is currently processing an event involving such inter-container coordination. This mechanism helps prevent potential conflicts or resource contention during sensitive distributed operations like merging.

**FIG. 7** - **13** illustrates non-limiting examples of the behavior and operations of the method and outage management system according to various embodiments of the present invention. These examples typically depict scenarios involving a set of two containers, referred to herein as Container 1 (potentially corresponding to container system **2001)** and Container 2 (potentially corresponding to container system **2002),** each comprising a unique directed network model, e.g., **2021a, 2022a,** representing a section of a power distribution system topology. These figures demonstrate how different event messages may be processed independently by the containers and how the topology models are dynamically managed.

**FIG. 7** illustrates an exemplary scenario involving the processing of a trouble report event message. An event message **2010a,** comprising a trouble report associated with a specific node is transmitted **102** (e.g., by OMS processor **2030** via OMS output interface **2040)** to the set of containers, including Container 1 and Container 2. Upon receiving the message via their respective container input interfaces **2011, 2012,** each container's processor **2031, 2032** performs the initial step of determining if the node associated with the trouble report is associated with a node within its own directed network model **2021a, 2022a.**

In the example shown, a first trouble report pertains to a node within the model of Container 2. Container 2 determines relevance and proceeds to perform the first set of suboperations **103,** executing a power distribution diagnosis based on the relevant node/edge and its model **2021a.** A diagnosis result **2041a** may be generated based on the outage interference and outputted via its container output interface **2041.** Container 2, determining the trouble report is not relevant to its model **2022a,** performs no diagnostic action or modification related to this first event message. This demonstrates the independent processing and distributed relevance determination intrinsic to the disclosed method and system. The container processing the relevant message effectively consumes or acts upon it, while the other ignores it in the context of model operations.

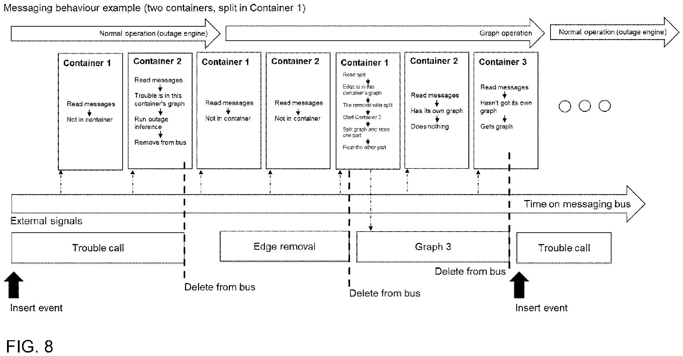

**FIG. 8** depicts a scenario following an initial trouble report where an event message comprising an edge removal request is transmitted **102** and received by Container 1 and Container 2. Assume the edge targeted for removal exists within the model **2021a** of Container 1 and is relevant. Container 1's processor **2031** executes the second set of suboperations step **104.** In this specific example, the edge being removed is one whose removal disconnects the graph represented in the model **2021a** comprised in Container 1 **2001.**

The operations performed by Container 1 **2001** is an example of the embodiment described in relation to FIG. 2 or 6. The container processor **2031** performs the edge removal **104a** and determines **104b** that the model must be split. It splits the model **2021a** into a first directed network model (which remains associated with Container 1) and a second directed network model **104c.** Subsequently, a new container 3 is initiated **104d,** comprising this second directed network model, and this new container 3 is added to the set of containers managed by the network node / OMS **2000.**

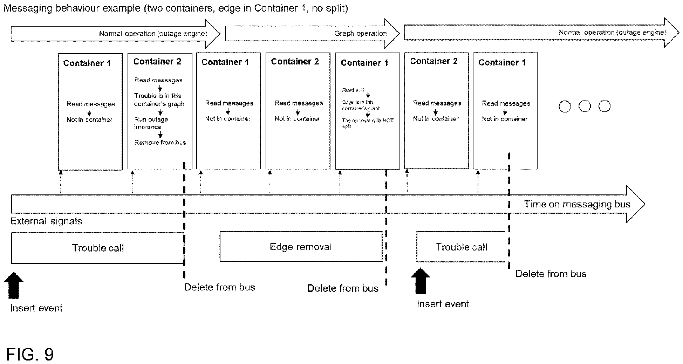

**FIG. 9** illustrates an alternative scenario for processing an edge removal request, again assumed relevant to Container 1's model **2021a.** Similar to Figure 8, the process involves the second set of suboperations **104.** However, in this example, the edge targeted for removal is part of a cycle or loop within the topology represented by the model **2021a.**

Consequently, when Container 1's processor **2031** removes the edge, a subsequent determination **104b** concludes that the graph remains connected and no split is necessary. Therefore, the operation concludes after removing the edge from the model **2021a.** No model splitting occurs, and no new container is initiated. This demonstrates the system's ability to handle edge removals that do not alter the fundamental partitioning of the topology across containers.

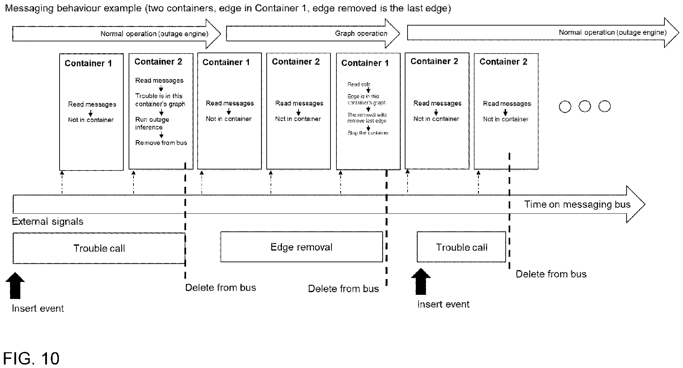

**FIG. 10** presents a scenario for an edge removal request relevant to Container 1's model **2021a.** Here, the edge specified for removal represents the last remaining edge within that container's model. Container 1's processor **2031** executes the removal operation **104.**

Upon removing this final edge, the directed network model **2021a** within Container 1 becomes empty or contains only isolated nodes with no connecting edges. In such embodiments, this state may trigger the decommissioning (i.e., removal) of Container 1 **2001** from the set of containers managed by the network node / OMS **2000,** as its represented topology section is now trivial or non-existent. The overall system continues operating with the remaining containers (e.g., Container 2).

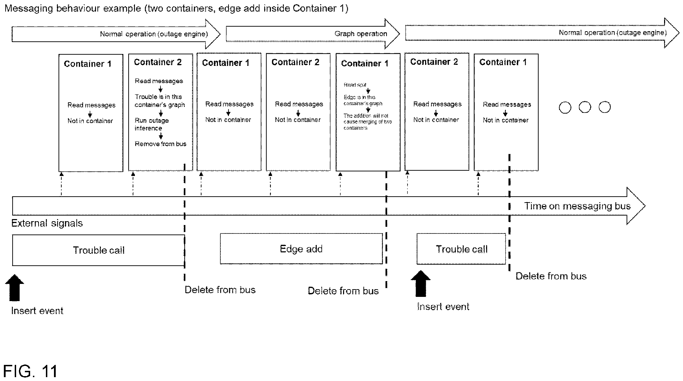

**FIG. 11** shows a scenario involving an add edge request. The event message is transmitted **102** the containers and is relevant to Container 1. The add edge request specifies a connection between two nodes, Node X and Node Y. Container 1's processor **2031** executes the third set of suboperations **105.**

This example corresponds to the situation described in relation to FIG. 3 where the determination **105a** finds that *both* Node X and Node Y correspond to nodes already present within Container 1's directed network model **2021a.** Therefore, the operation involves connecting these two nodes by adding the specified edge directly within the existing model **2021a, 1051.** No merging operation **1052** is needed, and the number of containers remains unchanged. This might, for instance, create a new loop within the topology section represented by Container 1.

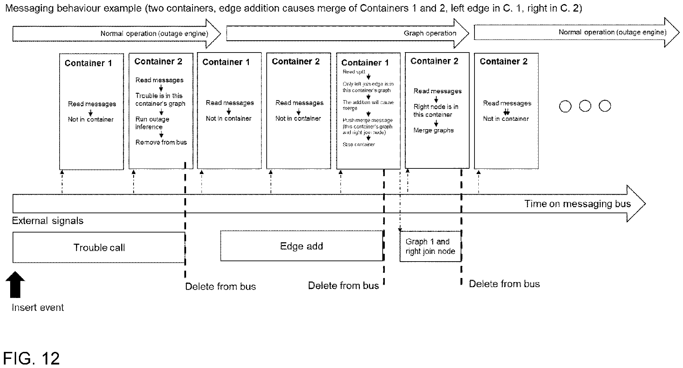

**FIG. 12** illustrates a more complex add edge scenario comprising an event message requests adding an edge between Node A (left edge in illustrated example) and Node B (right edge). In the example, Node A corresponds to a node within Container 1's model **2021a,** while Node B corresponds to a node within Container 2's model **2022a.** This situation triggers the merging aspect of the third set of suboperations **1052.**

This specific example demonstrates the push merge mechanism detailed in FIG. 4. In this example, a determination is made **1042a** that Container 1 should be removed post-merge. Container 1's processor **2031** transmits **1042b** a push merge message, containing its model **2021a** and the original add edge request, to all containers, including Container 2. Container 2's processor **2032** receives this message via its input interface **2012,** determines relevance **1042c** because Node B is in its model **2022a,** and proceeds to merge **1042d** the model received from Container 1 **2021a** with its own model **2022a.** The new edge connecting Node A and Node B is then added within this combined, merged model now residing solely within Container 2 (e.g., within container memory **2022).** Subsequently, Container 1 (e.g., container system **2001)** is effectively decommissioned or removed from the set of containers.

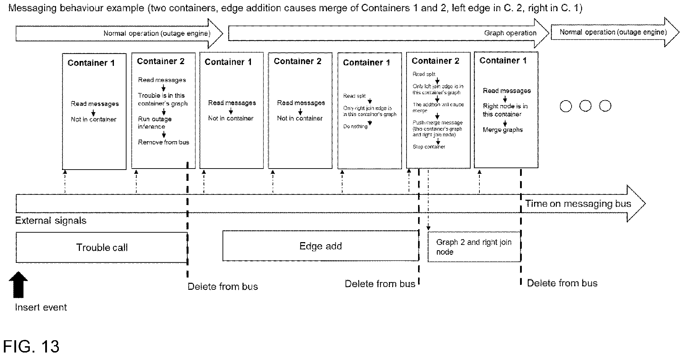

**FIG. 13** depicts a scenario logically identical to that of Figure 12, involving an add edge request connecting Node A (in Container 1's model **2021a)** and Node B (in Container 2's model **2022a),** thereby triggering a merge operation **1052.** In FIG 12 and 13 the determination **1042a** is made based on which container comprises the left vs right node such that the model **2021a, 2022a** comprising the right node is kept and the model **2021a, 2022a** comprising the left node is deleted. Which node is to the left vs right may be determined any way as long as the directed network models **2021a, 2022a** are consistent in their orientation.

In the exemplary execution of FIG. 13, the roles are reversed comparative to the example in FIG. 12 in that Node A is to the right and Node B is to the left. Consequently, the determination **1042a** selects Container 2 for removal post-merge. Container 2's processor **2032** transmits **1042b** the push merge message containing its model **2022a.** Container 1's processor **2031** receives this, determines relevance **1042c** based on Node A being in its model **2021a,** merges **1042d** the received model **2022a** into its own model **2021a,** and adds the new edge connecting Node A and Node B within the consolidated model now residing in Container 1 (or its memory **2021).** Subsequently, Container 2 (or container system **2002)** is decommissioned or removed from the active set of containers.

These examples collectively illustrate the dynamic and distributed nature of topology management enabled by the disclosed embodiments, allowing for efficient handling of various operational events impacting the power distribution system representation.

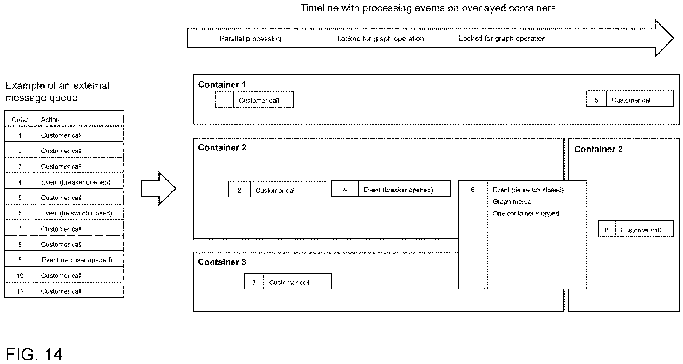

**FIG.14** provides a schematic timeline illustrating the temporal aspects of task execution across multiple containers, showcasing the parallel processing capabilities inherent in embodiments of the invention. Unlike FIG. 7 - 13 which focused on the specific topological changes or diagnostic actions resulting from individual events, FIG. 14 emphasizes how multiple containers (exemplified as Container 1, Container 2, Container 3, potentially corresponding to container systems **2001, 2002)** handle a sequence of events over time, potentially drawn from an external message queue (which could be related to the messaging queue **2020a** managed by the OMS processor **2030** according to embodiments of the second aspect).

The timeline demonstrates that multiple containers can operate concurrently on different event messages. For example, Container 1 might process event message '1' (e.g., a trouble report) while Container 2 simultaneously processes event message '2' (another trouble report) and Container 3 processes event message '3'. This parallel execution, explicitly labeled in the figure, is a direct result of the independent processing adaptation and the configuration of the container processors **2031, 2032** in the system **2001.** Each container performs its relevance check and subsequent suboperations largely independently for many event types.

However, FIG. 14 also illustrates periods labeled "Locked for graph operation" seen at the top. These periods correspond to more complex events that may require exclusive access to the container's model or coordination between multiple containers, such as the inter-container merge operation **1052** triggered by event '6' ("Event tie switch closed") in the example. While these "graph operation events" may originate from the same message queue as routine events, embodiments employ synchronization mechanisms to ensure they are not initiated or performed in parallel with conflicting operations. This might involve a logical semaphore and/or adherence to the predetermined prioritization protocol, where the method/OMS processor **2030** might defer transmitting new messages or prevent containers from starting certain operations while a critical inter-container action (like the depicted "Graph merge") is in progress. This ensures data integrity during sensitive operations that modify the distributed topology structure across container boundaries. During such locked periods, the involved containers (Container 1 and Container 2 in this example) might be temporarily unable to process other incoming events.

Consistent with the merge scenarios shown in FIG. 12 and 13, the timeline in FIG. 14 indicates that following the graph merge operation triggered by event '6', one container ("Container 1" in this depiction) is stopped or decommissioned. The figure thus visually summarizes the system's ability to leverage parallel processing for efficiency while implementing necessary coordination and serialization for complex, topology-altering events like merges, ensuring data integrity across the distributed model. This illustrates a practical execution flow embodying the principles of the disclosed method and system.

### Third aspect

According to a third aspect of the present invention there is proposed a method for processing a directed network model reflecting the topology of a power distribution system. This aspect particularly addresses the efficient updating of such a model in response to network events signifying topology changes, specifically the removal of an edge representing, for example, the opening of a switch or the failure of a line segment.

An embodiment according to the third aspect is illustrated in **FIG. 15** and comprises the following operations:
Receiving **201** a network event for processing comprising an edge removal request.
Retrieving **202** a directed network model reflecting the topology of the power distribution system. The directed network model includes a plurality of nodes and
edges. Each node represents at least one load or power source, and each edge represents at least one protection device or a power carrying line connecting two nodes.

The directed network model has been preprocessed such that:
- Edges have been assigned directions indicating the direction of power flow from power sources towards loads represented in the network mode. Wherein upstream direction of an edge is defined as a direction from at least one load to at least one power source, and wherein downstream direction of an edge is defined as a direction from at least one power source to at least one load;
- Loop edges and source edges are identified. A loop edge is an edge in the directed network model identified as belonging to at least one path that starts and ends at the same node without repeating any intermediate nodes, and wherein a source edge is an edge that is located on at least one path that interconnects two or more nodes representing power sources within the power distribution system;

Removing **203** the edge associated with the edge removal request from the directed network model.

If the removed edge is a loop edge in the directed network model: the network node adjusts **204a** the directions of relevant edges in the directed network model. However, if the removed edge is not a loop edge in the directed network model: the network node splits 204b the directed network model at the removed edge.

Then, if the edge is a source edge, the network node adjusts **205a** the directions of relevant edges in the directed network model. If the edge is not a source edge, the network node may end processing relating to the received network event.

The initial identification of loop edges during preprocessing may involve applying graph traversal algorithms capable of detecting cycles, such as: Simple Cycles (D.B. Johnson), Depth-First Search (DFS) for Cycle Detection, Union-Find Algorithm for Cycle Detection, Floyd's Cycle-Finding Algorithm. Similarly, identifying source edges may involve executing pathfinding algorithms (e.g., DFS) between all pairs of nodes designated as power sources within the network model to identify edges forming part of such inter-source paths

Adjusting 204a, 205a the direction of an edge entails modifying the data attribute representing the power flow direction associated with the edge, typically by performing graph traversal algorithms to determine the correct direction for the edge and if relevant, reversing the existing direction of the edge.

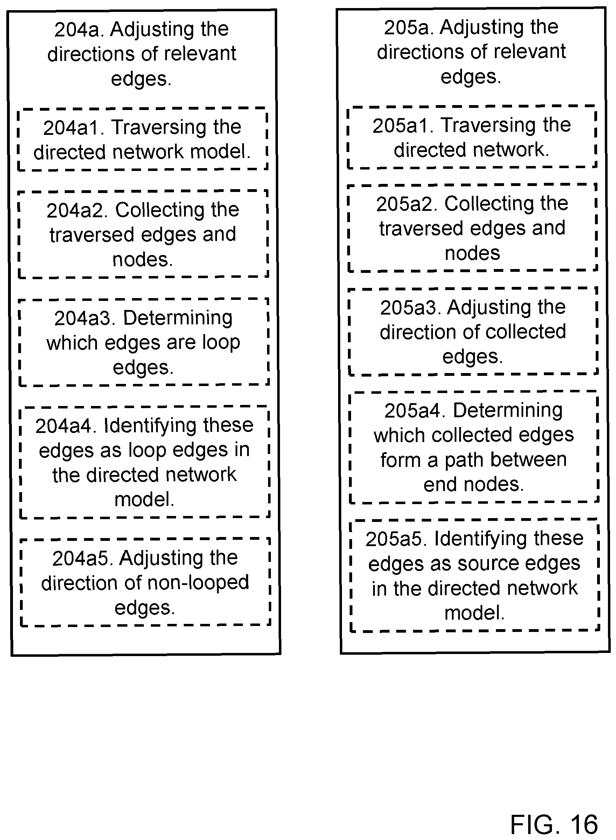

**FIG. 16** illustrates embodiments according to the third aspect relating to how the network node may adjust 204a, 205a the relevant edges in the directed network model.

The embodiment to the left in FIG. 16 illustrates how the network node may adjust 204a the direction of relevant edges if the removed edge is a loop edge. This embodiment comprises the following operations:
Traversing **204a1** the directed network model using exclusively the edges identified as loop edges, preferably starting from each node associated with the removed edge.

Collecting **204a2** the traversed 204a1 edges.

Determining **204a3** which edges among the collected 204a2 edges are loop edges and identifying **204a4** these edges as loop edges in the directed network model. For example, by using a simple cycle graph traversal algorithm to find loop edges among the collected 204a2 edges and associate the looped edges found with the label "loop edge".

The method may additionally adjust **205a5** the direction of non-loop edges among the collected 204a2 edges. This adjustment may e.g., use a graph traversal algorithm to adjust the direction of non-looped edges starting from the traversed nodes connected to at least one edge exclusively associated with an upstream direction.

In a further embodiment the traversed nodes connected to at least one edge exclusively associated with an upstream direction are collected, and the traversal made when adjusting 204a5 may originate from these collected nodes. In other words, the above determination 204a3 and adjustment originates from the traversed nodes connected to at least one edge exclusively associated with upstream direction (i.e., not downstream as well as upstream direction). For example, loop edges and source edges associated with both downstream and upstream direction, as such nodes exclusively connected to e.g., loop edges would not be collected as these edges would not be connected to any edge exclusively associated with an upstream direction. To exemplify, consider a scenario wherein a traversed node connects to three edges: two "loop edges" and one single direction edge. In this scenario the network node collects the node that apart from connecting loop edges also connects to single direction edge.

These embodiments ensure accurate and computationally efficient methodology for the recalculation of power flow directions and loop status within a network section immediately following the opening of a loop. By systematically traversing the remaining loop segments and re-evaluating edge types and directions locally, the method correctly updates the model to reflect the altered topology without requiring global analysis, thereby contributing to the efficiency and accuracy of the update process.

The embodiment to the right in FIG. 16 illustrates how the network node may adjust 205a the direction of relevant edges if the removed edge is a source edge. This embodiment comprises the following operations:
Traversing **205a1** the directed network model using exclusively the edges identified as source edges starting from each node associated with the removed edge until reaching a source node or non-looped source edge.

Collecting **205a2** the traversed 205a1 edges and nodes.

Adjusting **205a3** the direction of non-looped edges among the collected 205a1 edges to upstream.

Determining **205a4** which edges form a path between end nodes among the collected 205a2 traversed edges and nodes (e.g., by employing BSF-based algorithms) and identifying 205a5 these edges as source edges in the directed network model.

The traversal operation 204a1 typically employs a graph search algorithm, such as BFS (Breadth-First-Search) or DFS (Depth-First-Search), initiated from each node endpoint of the removed edge. The search is constrained to explore only along edges currently designated or identified as 'loop edges' within the directed network model.

Collecting 204a2, 205a2 involves storing identifiers (or references to the objects themselves) of the edges and nodes encountered during the traversal 204a1, 205a1 into a temporary data structure, like a set or list.

The act of identifying 204a4, 205a4 edges as loop edges or source edges involves assigning or updating a specific attribute, flag, or value associated with the respective edge representations within the data structure of the directed network model. This explicitly marks or designates them as e.g., 'loop edges' following the adjustment process, distinguishing them from non-loop edges.

This embodiment provides a computationally efficient methodology for handling the topological and flow direction changes resulting from the severance of an interconnection between power sources. It ensures that the model correctly reflects the new supply paths and updates the identification of edges critical to understanding the multi-source configuration, preserving the model's integrity for applications sensitive to power source arrangements and associated fault current paths. This embodiment allows for the method to correctly update the model to reflect the altered topology without requiring global analysis, thereby contributing to the efficiency and accuracy of the update process.

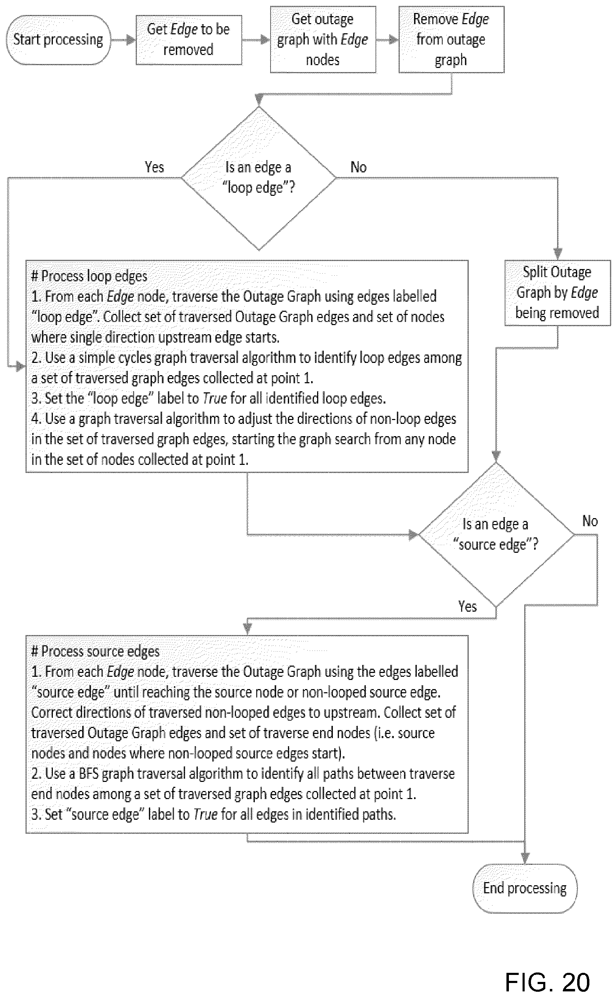

FIG. 20 further illustrates one embodiment according to the third aspect.

### Fourth aspect

According to a fourth aspect of the present invention there is proposed a method for processing a directed network model reflecting the topology of a power distribution system, focusing specifically on the efficient handling of updates resulting from a network event comprising an edge addition. Such an event may correspond, for instance, to the closing of a normally open tie switch or the integration of a new power line segment into the network.

**FIG. 17** Illustrates an embodiment according to the fourth aspect and comprises the following operations:
Receiving **301** a network event for processing, said event comprising an add edge request. The request specifies unique identification codes (IDs) for two nodes intended to be connected by the new edge.

Retrieving **302** at least one directed network model pertinent to the add edge request. This retrieval targets directed network models containing at least one of the two nodes specified in the request. The retrieved model(s) reflect the topology of the power distribution system, comprising a plurality of nodes and edges, wherein each node represents at least one load or power source, and each edge represents at least one protection device or a power carrying line interconnecting two nodes.

Each directed network model amongst the retrieved 302 model(s) has been preprocessed such that:
- Each edge has been assigned a direction indicating the power flow from a power source towards a load. Upstream direction of an edge is defined as a direction from at least one load to at least one power source, and downstream direction of an edge is defined as a direction from at least one power source to at least one load.
- Loop edges and source edges have been identified. A loop edge is part of a cycle (a path starting and ending at the same node without repeating intermediate nodes). A source edge lies on a path interconnecting two or more distinct power source nodes.

The subsequent action depends on the outcome of the retrieving 302 operation:
- If the retrieving 302 operation yields two distinct directed network models (implying the nodes to be connected were previously in electrically separate parts of the modeled system), the method proceeds by merging **304a** these two models into a single, unified directed network model. Following this, the network node adds the new edge, connecting the two specified nodes within this merged model.
- Conversely, if the retrieving 302 operation yields only one directed network model (indicating the nodes were already within the same modeled electrical section), the network node proceeds directly by adding **304b** the new edge to connect the two specified nodes within that existing model.

Following the adding 304a, 304b of the edge, the method identifies **305a** potential new loop edges and identifies **306a** potential new source edges.

This fourth aspect enables for an efficient and structured approach for updating the directed network model when network connectivity is increased via edge addition. It correctly handles scenarios involving the joining of previously disconnected network sections through model merging and employs targeted post-addition processing to identify only the specific edges whose status changes (becoming loop or source edges) as a direct result of the addition.

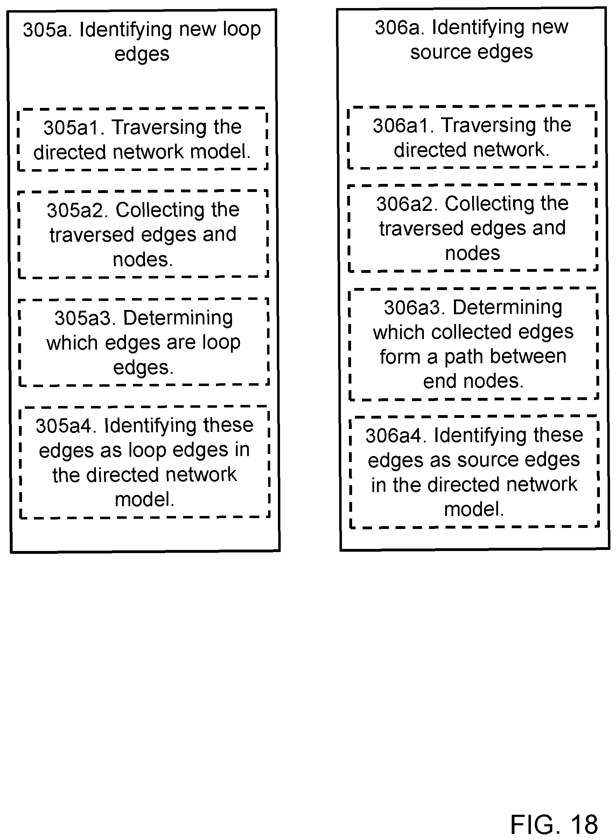

**FIG. 18** provides illustrative embodiments detailing the specific operations involved in identifying 305a new loop edges and identifying 306a new source edges.

The embodiment depicted on the left in FIG. 18 illustrates the process of identifying **305a** new loop edges, consequent to the adding 304a, 304b operation. This embodiment comprises:
- Traversing **305a1** the directed network model in the upstream direction, commencing from each of the two nodes associated with the newly added 304a, 304b edge. This traversal continues until at least one node designated as a power source is reached.
- Collecting **305a2** the edges encountered during the traversing 305a1 operation.
- Determining **305a3** which specific edges within the collected 305a2 edges constituting parts of any newly formed loops. This may e.g., be determined 305a3 using a simple cycle graph traversal algorithm adapted to distinguish loop edges.
- Identifying **305a4** these determined 305a3 edges explicitly as 'loop edges' within the data representation of the directed network model.

This embodiment provides a focused technique for detecting loop formation caused by edge addition. By performing limited upstream traversals from the points of connection and analysing the resulting paths, it efficiently identifies the newly cyclic portions of the network without necessitating a full graph traversal or cycle detection across the entire model, thereby contributing significantly to the computational efficiency of the model update process.

The embodiment depicted on the right in FIG. 18 illustrates the process of identifying **306a** new source edges, also consequent to the adding 304a, 304b operation. This embodiment comprises:
- Traversing **306a1** the directed network model in the upstream direction, starting from each node associated with the newly added 304a, 304b edge. This traversal proceeds until reaching at least one source node or at least one source edge which is not a loop edge and collecting the traversed edges and traversed end nodes;
- Collecting **306a2** both the edges encountered during the traversing 306a1 operation and terminal nodes reached at the conclusion of each traversal path (the 'end nodes').
- Determining **306a3** which paths, if any, can be constructed exclusively using the edges contained within the collected 306a2 edges and nodes, such that these paths interconnect the 'end nodes' also contained within the collected 306a2 edges and nodes. This may e.g., be determined 306a3 using graph traversal algorithm.
- Identifying **306a4** every edge that forms part of any such determined 306a3 path explicitly as a 'source edge' within the directed network model's data structure.

This embodiment ensures the accurate identification of new or altered paths between power sources resulting from the edge addition. By tracing upstream connectivity to existing source infrastructure points and analysing the connectivity established within the relevant subgraph defined by the collected elements, the method correctly updates the identification of all edges involved in newly formed source-to-source connections. This avoids computationally expensive global re-analysis of the entire network topology, thereby minimizing update latency and maintaining an accurate model representation suitable for time-sensitive OMS applications.

The merging 304a operation typically involves combining the node and edge sets of two distinct graph data structures, ensuring consistent identification and resolving any potential namespace conflicts. The adding of an edge involves instantiating a new edge object and associating it with the two specified node objects within the model's data structure.

The traversing operations 305a1, 306a1 necessitate graph search algorithms, such as BFS or DFS search algorithms initiated from the specified nodes and constrained by the upstream directionality and stopping criteria. Collecting 305a2, 306a2 involves accumulating identifiers or references to graph elements in suitable data structures (e.g., lists, sets). Determining 305a3, 306a3 incorporates logic known to the skilled person for cycle detection within the collected edge set (for loop edges) or pathfinding between collected end nodes using only collected edges (for source edges). Identifying 305a4, 306a4, as before, entails updating attributes or flags associated with the edge representations in the model to mark their status as 'loop edge' or 'source edge'.

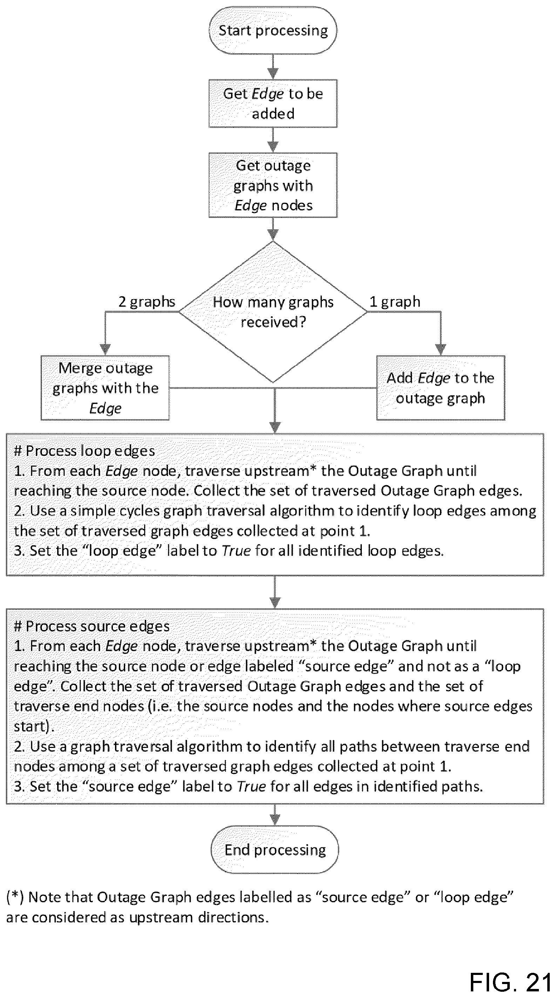

**FIG. 21** further illustrates one embodiment according to the fourth aspect.

### Third & fourth aspect

A key advantage conferred by the methods pursuant to the third and fourth aspects resides in the accelerated creation of new directed network models, critically avoiding full preprocessing subsequent to each topological alteration. This efficiency is particularly beneficial for extensive power distribution systems, including architectures managed in a partitioned or distributed manner.

Conventional approaches necessitating complete model generation and full preprocessing impose significant computational latency. In contrast, the present methodologies may operate incrementally upon the saved last version of the created and preprocessed directed network model, thus allowing new directed network models to be created by retrieving existing network models and performing e.g., merging 304a or splitting 204b operations.

This is made possible since a network event 201, 301 triggers targeted, localized updates 204a, 205a, 305a, 306a. Specific operations such as adjusting edge directions 204a, 205a, and re-determining loop 305a or source 306a edge status rely on limited traversals 204a1, 205a1, 305a1, 306a1 confined primarily to affected subgraphs or segments.

In this way, operations like splitting 204b a model or merging 304a models provide efficient mechanisms for recycling previously preprocessed network models.

Consequently, by obviating repeated, computationally burdensome full preprocessing, the described methodologies substantially reduce latency and computational load when creating new models, ensuring the timely availability of an accurate model for subsequent analyses (e.g., problem inference, simulation, load flow) and enhancing overall system scalability.

According to embodiments of the third and/or fourth aspect, the method further comprises subsequent operations relating to the utilization of the processed directed network model.

It should be understood that the processed directed network model refers to the directed network model after having been adjusted according to the method according to the third aspect, fourth aspects or embodiments thereof.

These subsequent operations may comprise utilizing the processed directed network model to performing: power distribution problem inference on the power distribution system; simulating the impact of a proposed sequence of switching operations on the power distribution system; and/or, load flow calculation for the power distribution system.

In one embodiment of the third and/or fourth aspect, the method comprises: receiving sensor data indicative of a potential power distribution problem within the power distribution system; performing a power distribution problem inference analyses utilizing the processed directed network model, wherein the analysis calculates potential fault current paths or analyses network connectivity based at least in part on the identified loop edges and/or source edges to correlate the sensor data with a probable fault location; and outputting data representing the probable power distribution problem location.

The dynamic and accurate identification of loop edges and source edges, achieved through the method according to the third or fourth aspect described herein following network topology modifications, provides significant technical advantages for fault location algorithms within an Outage Management System (OMS). By incorporating the up-to-date status of these edges, the fault location analysis can more accurately interpret sensor data (e.g., from protective relays, fault passage indicators, or smart meters). For instance, the knowledge of loop edges allows for correct modeling of parallel fault current paths, while identified source edges enable accurate assessment of fault current contributions from multiple infeeds or potential backfeed conditions. This refined analysis, based on the processed directed network model, leads to a more precise determination of the probable fault location, reducing patrol times for repair crews and accelerating service restoration, thereby directly impacting the operational performance and reliability of the physical power distribution system."

In another embodiment of the third and/or fourth aspect, the method further comprises: receiving at least one network events representing a proposed sequence of switching operations within the power distribution system; simulating the impact of the proposed sequence of switching operations on the power distribution system using the processed directed network model, wherein the simulation predicts power flows, voltages, or loading conditions based at least in part on the identified loop edges and/or source edges resulting from the simulated operations; and generating an output indicative of the technical feasibility or consequences of executing the proposed sequence on the physical power distribution system.

Operational changes in power distribution systems, such as executing switching sequences for maintenance or restoration, require careful planning to avoid adverse effects on the physical grid. The method's ability to provide an up-to-date directed network model, incorporating the correct status of loop and source edges after any topology change, enhances the reliability of planning tools. By simulating proposed switching sequences using this accurate model, operators can predict the technical consequences - such as changes in load flow patterns influenced by newly formed or broken loops (loop edges), or shifts in supply paths due to altered connections between sources (source edges). This simulation allows for the validation of switching plans, ensuring that operations will not lead to component overloads, unacceptable voltage deviations, or unintended islanding within the physical network, thereby contributing directly to operational safety and grid stability.

In yet another embodiment, the method further comprising: performing a load flow calculation (e.g., state estimation) for the power distribution system utilizing the processed directed network model, wherein the calculation uses the identified loop edges to define network admittances and the identified source edges to define power injection points; and using the results of the load flow calculation to generate real-time data representing the operational state of the physical power distribution system for monitoring or control purposes.

Accurate real-time monitoring of the power distribution system state is essential for reliable operation. Load flow calculations and state estimation algorithms, which provide this monitoring capability, are highly sensitive to the accuracy of the underlying network model. The present method ensures that the model, particularly the identification of loop edges (which determine network impedance/admittance) and source edges (which define system inputs), is correctly updated following topological changes. By using this processed directed network model as input, load flow or state estimation algorithms produce more accurate results regarding real-time voltage magnitudes, phase angles, and power flows throughout the physical system. This enhanced accuracy improves situational awareness for grid operators and provides a more reliable basis for automated control actions (e.g., voltage regulation), directly contributing to the stability and efficiency of the physical power distribution system."

### Fifth aspect

**FIG. 19** illustrates an exemplary embodiment of a system **3000** for managing a power distribution system, according to a fifth aspect of the present invention. The system **3000,** which may constitute or be part of an Outage Management System (OMS) or a distribution management system (DMS), comprises an input interface **3010,** a memory **3020** (representing a non-transitory computer-readable medium), a processor **3030** (e.g., one or more processors), and potentially an output interface **3040,** all communicatively coupled.

In operation, the input interface **3010** is configured to receive network events pertinent to the power distribution system's topology. These network events may comprise requests for an edge addition or an edge removal between two specified nodes, reflecting physical changes like switch operations or line installations/failures. The input interface **3010** may also be configured to receive sensor data indicative of conditions within the physical power distribution system, such as measurements from SCADA systems, smart meters (AMI), or fault passage indicators, and based on such data generate network events.

The processing means **3030** is communicatively coupled to the input interface **3010** and the memory **3020.** The memory **3020** stores instructions which, when executed by the processing means **3030,** configure the system **3000** to perform the management tasks. Upon receiving a network event via the input interface **3010,** the processing means **3030** retrieves or accesses a directed network model, typically stored within memory **3020** or accessible via a database interface. This model reflects the power distribution system's topology, comprising nodes (representing loads, sources, junctions) and edges (representing lines, transformers, protection devices), and includes data identifying pre-existing or previously updated loop edges and source edges, along with edge directions indicative of power flow.

Pursuant to the received network event, the processing means **3030** processes the directed network model. This processing entails executing instructions stored in memory **3020** that implement the methodologies described in the preceding third and fourth aspects. Specifically, the processing means **3030** updates the model structure (adding or removing the specified edge) and then executes graph traversal algorithms originating from the affected nodes. These algorithms re-evaluate connectivity and re-identify which edges in the updated model now qualify as loop edges (part of a cycle) and/or source edges (part of a path between distinct sources), according to the defined criteria. This ensures the model's topological data, particularly the critical loop/source status, remains accurate following the physical network change.

In embodiments according to the fifth aspect, the system **3000** leverages this accurately processed model for further technical purposes. The instructions stored in memory **3020** further cause the processing means **3030** to perform at least one technical analysis related to the physical state or operation of the power distribution system. These analyses explicitly utilize the processed directed network model, incorporating the re-identified loop edges and/or source edges as input parameters.

For example, the technical analysis may comprise performing power distribution problem inference (fault location analysis). Here, the processing means **3030** uses the accurate topology, including loop/source information, to process trouble reports received via the input interface **3010** (e.g., protection trips) and determine what components are should be identified as experiencing a power distribution problem and acted upon.

Alternatively or additionally, the technical analysis may involve simulating the impact of proposed switching operations. The processing means **3030** uses the processed model to predict how executing a sequence of openings/closures (i.e., edge addition or edge removal) would alter power flows, voltages, or protection coordination, considering the network's meshed or multi-source nature as defined by the re-identified loop/source edges.

In another example, the technical analysis may be performing load flow calculations or state estimation. The processing means **3030** uses the accurate topology provided by the processed model, including the loop/source edge status, to compute the current operational state (voltages, flows) of the physical network based on available measurements.

Following the technical analysis, the processing means **3030** generates output data representing the result (e.g., the probable fault location, the simulation outcome, the calculated system state). This output data may be transmitted via the output interface **3040** to other systems, databases, or user displays, providing actionable information for controlling, monitoring, or making operational decisions regarding the physical power distribution system.

This system aspect thus provides a tangible apparatus specifically configured to not only efficiently maintain an accurate topological model in response to dynamic network changes but also to directly apply that enhanced model in performing technical analyses critical for the effective management and operation of the physical power distribution system.

### Sixth aspect

According to a sixth aspect of the present invention, illustrated in **FIG. 22****,** there is proposed a method performed by a network node. The method comprises the following steps.

Receiving trouble reports **601.** Each trouble report comprises a unique load identification code representing a load in a power distribution system. The load identification code is referred to as *load ID* in the illustrated embodiment and the terms *ID* and *identification code* are used interchangeably in the present description.

Marking **602** the load identification code associated with the trouble report as experiencing a power distribution problem for each received trouble report, and adding the marked load identification code to a first dedicated queue Q1. In the illustrated embodiment, the marking 602 of the load ID as experiencing a power distribution problem is referred to as marking 602 the load ID as problematic. It should be understood that the term problematic in this description thus refers to a component experiencing a power distribution problem.

Performing a first set of operations 603 for each marked load identification code in the first dedicated queue Q1 comprising the steps:
- Retrieving 603a at least one unique protection device identification code each representing a protection device located nearest the marked load identification code in any given direction upstream from the marked load identification code as seen in a directed network model reflecting the topology of the power distribution system.
- For each retrieved protection device identification code: storing 603b the marked load identification code in a first set S1 associated with the retrieved protection device identification code.

Marking 604 a protection device identification code as experiencing a power distribution problem if the protection device identification code fulfills a predetermined criteria set related to at least the first set S1 associated with the protection device identification code.

Adding 605 the marked protection device identification code to a second dedicated queue Q2 for further processing.

Performing a second set of operations 606 for each marked protection device identification code in the second dedicated queue Q2 comprising the steps:
- Retrieving 606a at least one unique protection device identification code representing a protection device located nearest the marked protection device identification code in any given direction upstream from the marked protection device identification code as seen in a directed network model reflecting the topology of the power distribution system.
- For each retrieved protection device identification code: storing 606b the marked protection device identification code in a first set S1 associated with the retrieved protection device identification code.

The "directed network model" is a model establishing the topological context necessary for identifying upstream and downstream protection devices. The network node may comprise the directed network model or it may communicate with a node that comprises said model. In certain embodiments elaborated upon below, the network node may retrieve (e.g., subsequently to receiving 601 the trouble report) the directed network model comprising a plurality of nodes and edges representing the power distribution system so that the network model is made into a directed network model which further represents the direction of power flow in the power distribution system. It should thus be understood that e.g., marking 602 the load ID as problematic or marking 604 a protection device ID might entail adjusting the directed network model to change metadata of the node associated with the load ID or the edge associated with the protection device ID.

The network node preferably retrieves 603a, 606a all identification codes for the protection devices located nearest the marked load identification code in any given direction upstream from the marked load identification code. However, in certain scenarios it might be preferable that some protection device identification codes are not retrieved such as if the protection device ID is associated with a protection device currently under repair / replacement.

The dashed arrow drawn between step 604 and 606b indicates that the network node marks 604 protection device IDs as experiencing a power distribution problem based on the outcome from the first set of operations 603 and the second set of operations 606. In other words, the network node may mark 604 a protection device ID as experiencing a power distribution problem irrespective of what other operations are under processing. This is possible since the marking 604 is performed when the predetermined criteria set is fulfilled. However, as the skilled person understands, the network node may e.g., check if the predetermined criteria set is fulfilled after the first set of operations or the second set of operations. As can be seen in FIG. 22, the method may further comprise:
In **FIG. 23** there are illustrated further embodiments according to the sixth aspect.
The arrows with a diagonal zigzag near its midpoint indicates that step 603a, 603b respectively step 606a, 606b are not illustrated but may still be performed.

In the illustrated embodiments on FIG. 23, the first set of operations 603 further comprises:
- associating the marked load identification code 603c with a first counter C2 indicating the amount of protection devices and/or loads located nearest the marked load identification code in any given direction downstream as seen in a directed network model reflecting the topology of the power distribution system.

As can also be seen, the second set of operations 606 further comprises:
- associating the marked protection device identification code 606c with a first counter C2 indicating the amount of protection devices and/or loads located nearest the marked protection device identification code in any given direction downstream as seen in a directed network model reflecting the topology of the power distribution system;
The first counter C2 may be used to determine when a protection device identification code should be marked as experiencing a power distribution problem. Meaning that, the predetermined criteria set may be related to both the first set S1 and first counter C2 associated with the protection device identification code.

It should be understood that either or both of operation 603c and 606c may be performed in embodiments, as well as that operation 603c respectively 606c are not dependent on operation 603a, 603b respectively 606a, 606b. Thus 603c respectively 606c may be performed either prior to or subsequently to, 603a, 603b respectively 606a, 606b.

In one proposed embodiment, as also illustrated in FIG. 23, the method further includes the operations:
Adding one count 601a to a trouble report counter C1 associated with each load identification code. This operation is performed for each trouble report.

If a trouble report counter is associated with a count above a predetermined threshold, the network node marks 602 the load identification code associated with the trouble report counter as experiencing a power distribution problem and adds the marked load identification code to a first dedicated queue Q1.

In embodiments, the predetermined criteria set may comprise a number of conditions. These conditions may for example relate to metadata associated with a protection device ID.

For example, in one proposed embodiment, which is also illustrated in FIG. 23, the method further comprises:
Marking 604 a protection device identification code as experiencing a power distribution problem if the protection device identification code is associated with a first set S1 and first counter C2 fulfilling at least one condition of the predetermined criteria set, said conditions being fulfilled 604a when:
- the first set S1 having a cardinality of one, and the first counter C2 having a count equal to one; and/or
- the first set S1 having a cardinality equal to a defined threshold, and the first counter C2 having a count greater than one.

The "defined threshold" referred to herein represents a predetermined numerical value, typically an integer greater than one, which signifies a critical size for the first set S1 when considered in conjunction with the state of the first counter C2. This threshold may be statically configured within the system, for instance, based on empirical data or network topology considerations, or it may be dynamically adjustable based on operational parameters or administrative settings. Its specific value determines the minimum cardinality of S1 required, when C2 exceeds one, to trigger the marking 604.

Furthermore, it is to be understood that the two conditions listed above, relating the cardinality of S1 and the count of C2, are exemplary instances of conditions that may constitute the predetermined criteria set. The set may encompass further or alternative conditions for triggering the marking 604. Such additional conditions could, without limitation, pertain to the rate of change of S1, the specific elements contained within S1, temporal constraints associated with the accumulation of counts or elements, relationships with other counters or sets (not explicitly shown), or other metadata associated with the protection device identification code beyond that directly influencing S1 or C2. The fulfillment of any one or a combination of conditions stipulated within the full predetermined criteria set may suffice to effect the marking 604.

In certain embodiments, the method performed by the network node further comprises operations related to establishing the topological context necessary for identifying upstream protection devices.

Specifically, the network node may perform the steps of:
- Retrieving a directed network model reflecting the topology of the power distribution system, the network model including a plurality of nodes and edges. Each node represents at least one load or power source and each edge represents at least one protection device or a power carrying component (e.g. line or transformer) connecting two nodes. The directed network model having been preprocessed such that each edge is assigned a direction indicating the direction of power flow from a power source towards a load represented in the network model. Within this directed network model, wherein upstream direction of an edge is defined as a direction from at least one load to at least one power source, and wherein downstream direction of an edge is defined as a direction from at least one power source to at least one load.

**In** an alternative embodiment, the network node retrieves an undirected network model, i.e., a network model that has not been preprocessed such that each edge is assigned a direction. **In** such an embodiment the network node may then be configured to preprocess the undirected network model as to create a directed network model.

**In** some embodiments, the operations of retrieving the network model may not be performed by the same network node that performs the steps 601, 602, 603, and 604. Instead, the network topology processing tasks 603, 606 (and potentially 602, 603) may be executed by a separate, distinct network entity, such as a dedicated topology processing server or a central network management system, which is in communication with the network node performing the primary method steps. In such distributed architectures, the network node responsible, for e.g., steps 601-604, would obtain the necessary topological information, specifically the identity of the relevant upstream protection devices for a given load ID as required for e.g., step 603a, from said separate network entity. This communication may, for instance, involve the network node querying the separate entity with a load ID and receiving the corresponding upstream protection device ID(s) in response via a predefined interface or protocol. Alternatively, the separate entity might periodically compute and push updated directed topology information or relevant upstream mappings to the network node, which then stores this information locally for use in e.g., step 603a or 606a.

In certain embodiments, the method performed by the network node, as described according to the sixth aspect and its associated embodiments, is further configured to enhance processing efficiency and throughput, particularly advantageous when dealing with high volumes of trouble reports concurrently or when analysing extensive and complex sections of the power distribution network. This enhancement is achieved through the implementation of parallel execution capabilities for specific operations within the method.

According to one such embodiment, the network node is configured such that the first set of operations 603, which is performed for each marked load identification code retrieved from the first dedicated queue Q1, may be executed in parallel.

Specifically, the processing associated with distinct marked load identification codes present in Q1 need not occur sequentially. The operations comprising retrieving the unique protection device identification codes located nearest upstream 603a for a given marked load identification code, and the subsequent storing 603b of that marked load identification code into the first set S1 associated with each retrieved upstream protection device identification code, can be performed concurrently for multiple marked load identification codes simultaneously or pseudo-simultaneously. The implementation of such parallel execution can leverage various parallel computing paradigms, including but not limited to multi-threading within the network node, utilizing multiple processor cores, or distributing the workload across multiple computing instances, depending on the specific system architecture.

The technical effect of enabling parallel execution for the first set of operations is a significant increase in the processing capacity for incoming trouble reports. This allows the system to more effectively handle bursts of reports, as typically occur during major disturbance events, thereby reducing latency in the initial aggregation of outage evidence at the first upstream protection device level and accelerating the overall response time of the outage management system.

According to another such embodiment, further enhancing the efficiency of the upstream inference propagation, the network node is configured such that the second set of operations 606, performed for items retrieved from the second dedicated queue Q2, may also be executed in parallel.

As previously detailed, the second dedicated queue Q2 serves to hold identification codes, primarily marked protection device identification codes deemed problematic based on the predetermined criteria set 604, for further upstream analysis. The second set of operations 606 involves processing these identification codes by retrieving their respective nearest upstream protection device identification code(s) 606a and storing the originating marked identification code (from Q2) in the first set S1 associated with the newly retrieved upstream protection device(s) (606b).

This parallel execution capability allows the network node to perform this second set of operations concurrently for multiple distinct identification codes present in and dequeued from the second dedicated queue Q2. Thus, the upstream tracing originating from multiple distinct points (marked protection devices) in the network can proceed in parallel. Again, suitable parallel computing techniques known to the skilled person may be employed for implementation.

The technical effect of parallelizing the second set of operations is the acceleration of the inference process, particularly in scenarios involving topologically deep networks requiring multi-level upstream traversal, or when analysing widespread events potentially caused by faults at higher levels in the network hierarchy or multiple simultaneous faults. By concurrently exploring different upstream paths originating from various marked protection devices, the time required to converge on the actual root-cause protection device(s) responsible for the observed outages is substantially reduced, leading to faster and more efficient service restoration efforts.

In one embodiment of the sixth aspect the method further comprises:
- generating, by the network node and based on said marked protection device identification code, an alert message identifying the protection device marked as experiencing a power distribution problem; and
- transmitting said alert message for display on a graphical user interface associated with an Outage Management System (OMS) configured for monitoring and managing the power distribution system.

In another embodiment of the sixth aspect the method further comprises:
- generating, by the network node and based on said marked protection device identification code, control data specifying the identified protection device; and
- transmitting said control data to an automated switching system or control interface configured to utilize said control data to perform a switching operation within the power distribution system related to the identified protection device.

In yet another embodiment of the sixth aspect the method further comprises:
- initiating, by the network node via an interface to an Outage Management System (OMS) and based on said marked protection device identification code, an operational workflow within the OMS, wherein said operational workflow includes procedures for dispatching a repair crew to a geographic location corresponding to the protection device marked as experiencing a power distribution problem.

### Seventh aspect

According to a seventh aspect of the present invention, now discussed with reference to FIG. 3, there is provided an Outage Management System (OMS) 3000 specifically configured for identifying potential problem locations within a power distribution system, thereby enhancing outage diagnostics.

The OMS 3000 comprises an input interface 3010. This interface is configured to receive data from various sources relevant to the state and structure of the power distribution system. Specifically, it is configured to receive trouble reports, such as those originating from customer calls logged in a Customer Information System (CIS), Automated Metering Infrastructure (AMI) alerts (e.g., 'last gasp' notifications), or SCADA alarms. Each trouble report comprises, or is associated with, a unique load identification code representing a specific load (e.g., a customer meter point or distribution transformer) within the network. The input interface 3010 is further configured to receive data representing a directed network model of the power distribution system, which may be sourced from a Geographic Information System (GIS) or network planning database and preprocessed to create a directed network model.

The OMS 3000 further comprises a memory 3020, which may include volatile and non-volatile storage components. The memory 3020 is configured to store operational data structures required for the inference process, including at least the first dedicated queue (Q1) for holding marked load identification codes awaiting processing, and the plurality of first sets (S1), wherein each set S1 is associated with a unique protection device identification code and stores the marked load identification codes potentially affected by that device. The memory 3020 is also configured to store configuration data, such as the predetermined criteria set used for marking protection devices as problematic, and potentially a local copy or relevant portions of the directed network model. If counters C1 and/or C2 are implemented, the memory 3020 would also be configured to store these counters. Communicatively coupled to the input interface 3010 and the memory 3020 are processing means 3030. The processing means may comprise one or more processors, microcontrollers, or application-specific integrated circuits (ASICs). The processing means 3030 are specifically configured by software instructions, hardware logic, or a combination thereof, to perform the core inference logic. This configuration includes executing the steps of:
- Receiving the trouble reports via the input interface 3010 (analogous to step 601).
- For each report, marking the associated load **ID** as problematic and adding it to Q1 stored in memory 3020 (analogous to step 602).
- Performing the first set of operations (analogous to step 603) for items in Q1, which involves retrieving upstream protection device IDs using the network model (analogous to step 603a) and storing the initiating load ID in the corresponding S1 set in memory 3020 (analogous to step 603b). This may also involve associating counters C2 (analogous to step 603c) if implemented.
- Evaluating protection device IDs against the predetermined criteria set stored in memory 3020, considering at least the associated S1 set (and potentially C2), and marking those fulfilling the criteria as experiencing a power distribution problem (analogous to step 604). This may involve applying specific conditions as detailed in embodiments of the sixth aspect.
- The processing means 3030 are configured to generate, based on identifying a marked protection device identification code, an output signal. This output signal is indicative of the specific protection device identified by the inference logic as being potentially problematic and related to the received trouble reports.

The OMS 3000 also comprises an output interface 3040, communicatively coupled to the processing means 3030. The output interface 3040 is configured to transmit the output signal generated by the processing means 3030. This transmission is directed towards other systems or interfaces where the information can be utilized in managing the power distribution system. Examples of such utilization include, but are not limited to: transmitting the signal to populate a graphical user interface map within the OMS itself, showing the likely faulted device; sending data to a work management system to automatically generate a trouble ticket or work order; providing input to a SCADA system for operator review or potentially initiating automated switching sequences; or logging the inferred result for performance analysis. The provision of this output interface ensures the result of the internal inference process is made available externally in a usable format for tangible actions related to grid operation and restoration.

In one embodiment according to the seventh aspect there is proposed that the processing means are further configured such that the generation of said output signal and its transmission via the output interface comprises performing the steps as recited in any of the embodiments according to the sixth aspect.

### First to seventh aspect

It is to be understood that the various aspects and embodiments described herein may be interrelated and combined. For instance, the methods for processing a directed network model according to the third aspect, illustrated in FIG. 15 and FIG. 16, and the fourth aspect, illustrated in FIG. 17 and FIG. 18, may be performed within the architectural framework described in the first and second aspects.

Specifically, the operation of retrieving **202** a directed network model, as set forth in the third aspect illustrated in FIG. 15, or retrieving **302** at least one directed network model, as set forth in the fourth aspect illustrated in FIG. 17, can be implemented within the context of the outage management system **2000** and associated container systems **2001, 2002** described in relation to FIG. 6. In such embodiments, the retrieving **202, 302** operation may be executed by a container processor, for example container processor **2031 or 2032,** accessing and retrieving its corresponding directed network model **2021a or 2022a** stored within its communicatively coupled container memory **2021 or 2022.**

Furthermore, the preprocessing steps mentioned in the third aspect, concerning the assignment of edge directions and the initial identification of loop edges and source edges, may be performed either prior to distributing the directed network models into the set of containers **2001, 2002** or within each container system upon initialization or modification. The subsequent processing steps involving adjusting edge directions **204a, 205a,** splitting the model **204b,** or identifying new loop edges **305a** and source edges **306a,** as detailed in the third and fourth aspects, may then be executed by the respective container processors **2031, 2032** manipulating the directed network model **2021a, 2022a** residing in their local container memory **2021, 2022.**

Similarly, the system **3000** described in the fifth aspect, illustrated in FIG. 19, may incorporate the distributed processing architecture of the first and second aspects. The processing means **3030** and memory **3020** may represent the collective resources of the main outage management system processor **2030** and the set of container processors **2031, 2032,** along with their respective memories **2020, 2021, 2022.** In such a configuration, the processing means **3030** retrieves the directed network model by accessing the relevant segments **2021a, 2022a** stored across the distributed container memories **2021, 2022,** and the processing according to the third or fourth aspect is performed in a distributed manner by the container processors **2031, 2032** operating on their respective model partitions. The technical analyses performed subsequently, such as power distribution problem interference, simulation, or load flow calculation, may likewise leverage this distributed architecture, potentially coordinating calculations across multiple container systems **2001, 2002** based on the accurately maintained and processed distributed topology representation.

Furthermore, the methodological framework defined in the sixth aspect, pertaining to the management of a power distribution system through trouble report processing and upstream device identification, illustrated conceptually in FIG. 22 and FIG. 23, can be synergistically executed within the distributed processing architecture delineated in the first and second aspects (ref. FIG. 6).

Specifically, the initial step of receiving 601 trouble reports, each comprising a unique load identification code, may be handled by the main outage management system 2000, potentially via its primary input interface, which then intelligently routes or makes available these reports to the relevant container systems 2001, 2002 based on the geographic or topological domain associated with the load identification code. The subsequent marking 602 of the load identification code as problematic and its addition to the first dedicated queue Q1 can occur within the context of the container system responsible for that network segment, managed by the respective container processor 2031, 2032 utilizing its local container memory 2021, 2022.

The core operations of the sixth aspect, namely the first set of operations 603 (retrieving 603a upstream protection device IDs and storing 603b load IDs in associated S1 sets) and the second set of operations 606 (retrieving 606a further upstream device IDs and storing 606b originating device IDs in their S1 sets), intrinsically rely on the directed network model. This model, potentially preprocessed according to the third or fourth aspects and distributed as segments 2021a, 2022a across container memories 2021, 2022, provides the necessary topological context. The retrieval steps 603a and 606a would thus be executed by container processors 2031, 2032 performing traversals within their local model partition 2021a, 2022a.. The management of the first sets S1, and potentially the counters C1 and C2 referenced in embodiments, can likewise be distributed, with each container processor managing the sets and counters pertinent to the devices within its partition, stored in its local memory 2021, 2022.

The step of marking 604 a protection device identification code as problematic based on the predetermined criteria set (related to S1, and potentially C2 and other conditions 604a) can be performed by the individual container processors 2031, 2032 evaluating the state of S1 sets and counters stored locally. The subsequent addition 605 of marked device IDs to the second dedicated queue Q2 follows a similar logic, being managed either locally within containers or centrally. Notably, the parallel execution capabilities described in embodiments of the sixth aspect for operations 603 and 606 align naturally with the distributed architecture, wherein a container processor 2031, 2032 can concurrently process items from Q1 and Q2, significantly enhancing throughput.

Congruently, the outage management system 3000 described in the seventh aspect, illustrated in FIG. 3 (and analogous to the system 3000 referenced in the fifth aspect), can be concretely realized using the distributed architecture of the first and second aspects (system 2000, FIG. 6). In this realization, the processing means 3030 of the seventh aspect would correspond to the combined computational resources of the main processor 2030 and the set of container processors 2031, 2032. The memory 3020 would represent the collective storage comprising the main memory 2020 and the container memories 2021, 2022, configured to store the queues (Q1, Q2), sets (S1), counters (C1, C2), criteria, and the distributed network model (2021a, 2022a). The input interface 3010 and output interface 3040 map to the external communication interfaces of the overall system 2000. The processing means (2030, 2031, 2032) would execute the steps detailed in the sixth aspect in a distributed manner as described above. The generation and transmission of the output signal via the output interface 3040, indicating the identified problematic protection device for utilization (e.g., generating alerts, control data, or initiating workflows as per embodiments of the sixth aspect), would typically be coordinated and effected by the main processor 2030 based on the conclusive marking 604 derived from the distributed processing activities.

### Definitions

Each "container" is basically a fully functional and portable cloud or non-cloud computing environment surrounding the application and keeping it independent of other environments running in parallel. In other words "containers" are lightweight packages of application code together with dependencies such as specific versions of programming language runtimes and libraries required to run your software services. Within the context of the present patent application, "container" refers to an encapsulated software entity that houses a directed network representation of part or all of a power distribution infrastructure. This representation includes the system's nodes, edges, and any operational or diagnostic logic needed to execute prescribed tasks

As used herein, the term "network node" refers to an entity, implemented in hardware, software, or a combination thereof, that is configured to process, exchange, or manage data within a networked environment of a power distribution system. The network node may include one or more computing devices, control units, or communication interfaces and may be operatively coupled to other networked components. The network node may, but need not, comprise an outage management system or functions typically associated with an outage management system.

An "Outage Management System" (OMS) is a software application used by utility companies to monitor, manage, and restore electrical service during outages. It integrates various data sources, such as geographic information systems (GIS), supervisory control and data acquisition (SCADA) systems, and customer service databases, to provide real-time information about the status and location of outages. Key features of an OMS may include: visualizing outages and affected areas through mapping tools; and, facilitating the coordination of repair crews and resources to expedite service restoration.

A "Power Distribution System" (PDS) encompasses a network of components that deliver electricity from one or several transmission system to individual consumers. This system includes various elements such as substations, transformers, distribution lines, and circuit breakers. The key functions and characteristics of a PDS include: reducing high-voltage electricity from the transmission system to a lower voltage suitable for consumer use; and, balancing the demand for electricity among various consumers and implement various protective devices or mechanisms to ensure stability and reliability. The term "power distribution system" may thus comprise of one large interconnected transmission system or several independent sub-transmission systems.

The term "communicatively coupled" implies the ability to exchange data. It should be understood that this coupling can be achieved through diverse means, encompassing direct hardware links, system buses, local area networks (LANs), wide area networks (WANs), wireless communication protocols, message queuing systems, or application programming interfaces (APIs) over networks like the internet.

For the purposes of this specification, where the terms "power distribution problem," "outage" used interchangeably. The term "power distribution problem" shall be understood to denote an event, state, or condition within or affecting the power distribution network that constitutes, indicates, or directly results in a loss of electrical service continuity to one or more customer service points, and which is typically detected, validated, managed, or resolved using an Outage Management System (OMS). Such power distribution problems, being inherently problematic due to the interruption of service, primarily encompass:
- A complete and sustained loss of power supply (outage) to customer endpoints, particularly unscheduled interruptions arising from faults or equipment failure;
- Events registered by network monitoring (e.g., SCADA protective device operations) or customer interaction systems (e.g., validated customer calls, AMI alerts like 'last gasp') that correlate to, or are determined by the OMS to represent, an actual service interruption requiring intervention;
Essentially, within this context, a "power distribution problem" is an actionable service interruption event falling under the management purview of an OMS, triggering its functionalities for location, resource allocation, and restoration coordination.

The term "directed network model", also referred to as "network model" or "model" herein, refers to a network model reflecting the topology of a power distribution system. The network model including a plurality of nodes and edges. A "node" represents an entity in the network model corresponding to a power system load, source, or significant junction point. A "edge" represents a connection between two nodes in the network model, corresponding to a power system component (e.g., line, transformer, protection device) facilitating or controlling power flow. The network model as referred to herein refers to a model that has been preprocessed such that each edge is assigned a direction (upstream or downstream) indicating the direction of power flow from a power source towards a load represented in the network model. "Upstream" refers to relative direction in the directed network model towards the supplying power source(s), generally counter to the assigned power flow direction on radial segments. Meaning that, traversal along identified Loop Edges or Source Edges is defined as moving upstream and downstream. "Downstream" refers to the relative direction in the directed network model opposite to upstream, moving away from source(s) towards loads, generally following assigned power flow on radial segments. Directed network models are typically further preprocessed as to identify loop edges and source edges. "Loop edge" is an edge identified during preprocessing as part of a cycle (a closed path) within the directed network model, characteristic of meshed topologies. "Source edge" is an edge identified during preprocessing as part of a path connecting two or more distinct power source nodes within the directed network model.

For the purposes of traversals, particularly those aimed at identifying paths towards sources or analyzing connectivity within loops or between sources (as pertinent in the third and fourth aspects), traversal in either direction along an edge designated as a "loop edge" or a "source edge" may be considered an "upstream" traversal. This reflects the nature of such edges as potentially forming part of complex paths connecting back to sources or interconnecting multiple sources, where a simple single power flow direction is insufficient to capture the topological relationship relevant for specific analyses like loop or source path identification.

The term "relevant edges" as utilized in the present patent disclosure refers to edges that are relevant to adjust subsequently to an topological change, e.g., a edge removal or addition. Embodiments for determining 204a3, 205a4, 305a3, 306a3 what edges are relevant to adjust are described in embodiments of the aspects disclosed herein.

## Claims

1. A method performed by a network node comprising:
retrieving a set of containers, wherein each container comprises a directed network model reflecting the topology of a power distribution system, the at least one directed network model including a plurality of nodes and edges, wherein each node represents at least one load or power source, and wherein each edge represents at least one protection device or a power carrying line connecting two nodes; and,
wherein each directed network model in the set of containers reflects a unique section of the topology of the power distribution system;
transmitting an event message to each of the containers in the set of containers, wherein the event message comprises either: i) an add edge request associated with two nodes to be connected; ii) an edge removal request associated with an edge to be removed; or, iii) a trouble report associated with a node that has been determined to be associated with a power distribution problem; and,
within each container in the set of containers, performing a set of operations adapted for independent processing relative to other containers in response to receiving an event message, the set of operations comprising: determining if a node or edge associated with the event message is associated with a node or edge within the directed network model comprised in the container, and wherein the set of operations comprises a first set of suboperations comprising:
(1) if the event message is a trouble report, perform a power distribution problem diagnosis based on the node and/or edge associated with the trouble report and the directed network model comprised in the container;
wherein the set of operations further comprises a second set of suboperations comprising:
(2) if the event message is a remove edge request, removing the edge associated with the remove edge request from the directed network model comprised in the container;
wherein the set of operations further comprises a third set of suboperations comprising:
(3) if the event message is an add edge request, connecting the two nodes associated with the add edge request by adding an edge to the directed network model comprised in the container.

2. The method according to claim 1, wherein the second set of suboperations further comprises:
(2) if the event message is a remove edge request, removing the edge associated with the remove edge request and determining if the directed network model should be split into two directed network models and if so, splitting the directed network model into a first directed network model and a second directed network model and, initiating a new container comprising the second directed network model such that the new container is comprised in the set of containers.

3. The method according to claim 1 or 2, wherein the third set of suboperations further comprises:
(3) if the event message is an add edge request, determining if one or both nodes among the two nodes to be connected is associated with one or two nodes in the directed network model comprised in the container and, if both nodes among the two nodes to be connected is associated with two nodes in the directed network model comprised in the container, connecting the two nodes to be connected in the directed network model comprised in the container, and if only one first node among the two nodes to be connected is associated with the directed network model comprised in the container, merging the container comprising the directed network model associated with the one first node with another container among the set of containers comprising a directed network model associated with the second node by adding a new edge connecting the two nodes to be connected in the merged directed network model.

4. The method according to claim 3, wherein the merging performed in the third set of suboperations is performed by:
- determining if the container or the other container should be removed from the set of containers, and wherein the container to be removed performs the operations of: transmitting a push merge message comprising at least the directed network model comprised in the container to be removed and the event message to each container in the set of containers, wherein each container in the set of containers in response to the received push merge message, determines if the second node among the two nodes to be connected is associated to the directed network model comprised in the container and if so, merge the directed network model comprised in the push message and adding a new edge connecting the two nodes to be connected in the merged directed network model.

5. The method according to any previous claim, wherein the method further comprises:
receiving an event message and storing said event message in a messaging queue;
determining what event message stored in the messaging queue should be transmitted to the set of containers based on a predetermined prioritization protocol.

6. The method according to claim 5, wherein the predetermined prioritization protocol comprises:
determining if at least one container is processing an event message involving two containers and if so, defer transmission of further event messages until there is no container that is processing an event message involving two containers.

7. The method according to any previous claim, wherein the third set of suboperations further comprises:
processing the directed network model with the added edge as to identify new loop edges;
processing the directed network model with the added edge as to identify new source edges.

8. The method according to claim 7, wherein the third set of suboperations further comprises processing the directed network model with the added edge as to identify new loop edges by performing the operations:
traversing the directed network model upstream from each node associated with the added edge until reaching at least one source node and collecting the traversed edges;
determining what edges amongst the collected edges are loop edges and identifying these edges as loop edges in the directed network mode.

9. The method according to claim 7 or 8, wherein the third set of suboperations further comprises processing the directed network model with the added edge as to identify new source edges by performing the operations:
traversing the directed network model upstream starting from each node associated with the added edge until reaching at least one source node and/or at least one source edge which is not a loop edge and collecting the traversed edges and traversed end nodes;
determining what paths are possible to form between the traversed end nodes amongst the collected edges and nodes using the edges among collected edges and nodes;
identifying each edge forming the determined at least one path as a source edge.

10. The method according to any previous claim, wherein the second set of suboperations further comprises:
if the removed edge is a loop edge in the directed network model, adjusting the directions of relevant edges in the directed network model; and, if the removed edge is not a loop edge in the directed network model, splitting the directed network model at the removed edge; and,
if the edge is a source edge, adjusting the directions of relevant edges in the directed network model.

11. The method according to claim 10, wherein the second set of suboperations further comprises:
if the removed edge is a loop edge in the directed network model, adjusting the directions of relevant edges in the directed network model by:
traversing the directed network model starting from each node associated with the removed edge using exclusivly the edges identified as loop edges and collecting the traversed edges;
determining which edges among the collected edges are loop edges and
identifying these edges as loop edges in the directed network model;
adjusting the direction of non-looped edges among the collected set of edges.

12. The method according to any claim 10 or 11, wherein the second set of suboperations further comprises:
if the edge is a source edge, adjusting the directions of relevant edges in the directed network model by:
traversing the directed network model starting from each node associated with the removed edge using exclusively the edges identified as source edges until reaching a source node or non-looped source edge and collecting the traversed edges and nodes;
adjusting the direction of collected edges;
determining which edges form a path between end nodes among the collected edges and nodes and identifying these edges as source edges in the directed network model.

13. The method according to any previous claim, wherein the first set of suboperations further comprises:
receiving trouble reports, wherein each trouble report comprises a unique load identification code representing a load in a power distribution system;
for each trouble report, marking the load identification code associated with the trouble report as experiencing a power distribution problem, and adding the marked load identification code to a first dedicated queue Q1
performing a first set of operations for each marked load identification code in the first dedicated queue Q1 comprising the steps:
- retrieving at least one unique protection device identification code each representing a protection device located nearest the marked load identification code in any given direction upstream from the marked load identification code as seen in a directed network model reflecting the topology of the power distribution system; and, for each retrieved protection device identification code:
storing the marked load identification code in a first set S1 associated with the retrieved protection device identification code;
marking a protection device identification code as experiencing a power distribution problem if the protection device identification code fulfills a predetermined criteria set related to at least the first set S1 associated with the protection device identification code;
adding the marked protection device identification code to a second dedicated queue Q2 for further processing; and,
performing a second set of operations for each marked protection device identification code in the second dedicated queue Q2 comprising the steps:
- retrieving at least one unique protection device identification code representing a protection device located nearest the marked protection device identification code in any given direction upstream from the marked protection device identification code as seen in a directed network model reflecting the topology of the power distribution system; and, for each retrieved protection device identification code:
storing the marked protection device identification code in a first set S1 associated with the retrieved protection device identification code.

14. An outage management system, comprising:
an outage management system input interface configured to retrieve an event message, wherein the event message comprises either: i) an add edge request associated with two nodes to be connected within a power distribution system; ii) an edge removal request associated with an edge to be removed within the power distribution system; or, iii) a trouble report associated with a node determined to be associated with a power distribution problem;
an outage management system output interface;
an outage management system processor communicatively coupled to the outage management system input interface and the outage management system output interface, wherein the outage management system processor is configured to:
receive said event message via the outage management system input interface; and
cause the outage management system output interface to transmit said received event message to a container input interface comprised in each container system in a set of container systems;
wherein each container system comprises:
- the container input interface communicatively coupled to the outage management system output interface;
- a container memory configured to store a directed network model reflecting the topology of a unique section of the power distribution system, the directed network model including a plurality of nodes representing at least one load or power source, and a plurality of edges representing at least one protection device or a power carrying line connecting two nodes;
- a container processor communicatively coupled to the container input interface and the container memory, wherein the container processor is configured to, in response to receiving an event message via the container input interface, perform a set of operations adapted for independent processing relative to other container systems, said set of operations comprising:
- determining if a node or edge associated with the event message received via the container input interface corresponds to a node or edge within the directed network model stored in the container memory; and, if said node or edge corresponds:
- performing a first set of suboperations comprising: if the event message is a trouble report, executing a power distribution diagnosis based on the corresponding node and/or edge and the directed network model stored in the container memory, and generating a diagnosis result;
- performing a second set of suboperations comprising: if the event message is a remove edge request, modifying the directed network model stored in the container memory by removing the corresponding edge; and,
- performing a third set of suboperations comprising: if the event message is an add edge request, modifying the directed network model stored in the container memory by adding an edge connecting the two corresponding nodes; and
- a container output interface communicatively coupled to the container processor, configured to output at least said diagnosis result.

15. The outage management system according to claim 14, wherein outage management system is configured to perform any of the operations of claim 1 to 13.
